(19) Europäisches Patentamt
European Patent Office
Office européen des brevets

(11) **EP 4 203 054 A1**

(12) **EUROPEAN PATENT APPLICATION**
published in accordance with Art. 153(4) EPC

(43) Date of publication:
**28.06.2023 Bulletin 2023/26**

(21) Application number: **21941410.9**

(22) Date of filing: **14.05.2021**

(51) International Patent Classification (IPC):
*H01L 27/32* (2006.01)    *G02F 1/133* (2006.01)

(52) Cooperative Patent Classification (CPC):
**G02F 1/133; H10K 59/00**

(86) International application number:
**PCT/CN2021/093966**

(87) International publication number:
**WO 2022/236841 (17.11.2022 Gazette 2022/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **BOE Technology Group Co., Ltd.**
**Beijing 100015 (CN)**

(72) Inventors:
• **JIN, Qian**
**Beijing 100176 (CN)**

• **HUANG, Wei**
**Beijing 100176 (CN)**
• **SUN, Qian**
**Beijing 100176 (CN)**
• **LU, Tianhao**
**Beijing 100176 (CN)**
• **LI, Yang**
**Beijing 100176 (CN)**
• **TIAN, Yu**
**Beijing 100176 (CN)**

(74) Representative: **Brötz, Helmut et al**
**Rieder & Partner mbB**
**Patentanwälte - Rechtsanwalt**
**Yale-Allee 26**
**42329 Wuppertal (DE)**

(54) **COLOR FILTER STRUCTURE AND PREPARATION METHOD THEREFOR, AND DISPLAY PANEL**

(57)    Embodiments of the present disclosure relate to a color filter structure and a preparation method therefor, and a display panel. The color filter structure (100) comprises: a plurality of color control units (102) located on a substrate (101), and a pixel defining layer (103) defining the plurality of color control units (102), wherein the plurality of color control units (102) are respectively defined in a plurality of openings 104 defined by the pixel defining layer (103); the pixel defining layer (103) comprises a plurality of spacer portions (105), each of the plurality of spacer portions (105) spaces two of the plurality of color control units (102) from each other, and an auxiliary portion (106) is provided on at least one side wall of the at least one spacer portion (105) facing the color control units (102); the compactness of the auxiliary portion (106) is greater than or equal to the compactness of the bottom of the spacer portion (105). Thus, flowing ink can be prevented from permeating into adjacent openings, thereby avoiding color crossover, thus avoiding the influence on a display effect.

FIG. 9

## Description

TECHNICAL FIELD

At least one embodiment of the present disclosure relates to a color filter structure, a preparation method of the color filter structure, and a display panel.

BACKGROUND

With the continuous development and progress of display technology, it is very important that display devices can present natural colors to the maximum extent and bring a real and shocking visual experience to viewers. In the realization of wide color gamut, an optional way is to use quantum dots (QD) to emit light. The realization of quantum dots relies on the advantages of narrow emission spectrum and high color purity of quantum dots. In the field of display, quantum dots emit light in two ways: photoluminescence and electroluminescence.

A specific implementation of photoluminescent quantum dots is quantum dots-color film (QD-CF). QD-CF can be combined with various blue backlight sources such as Liquid Crystal Display (LCD), organic light-emitting diode (OLED) and micro light-emitting diode (micro LED). Based on the excitation principle that blue light has a short wavelength (430nm~470nm) and a large energy, it can excite quantum dots to emit light with a long wavelength (that is, the energy required to be excited is small), so that the blue light passes through a color filter composed of red quantum dots and green quantum dots, which excite the red quantum dots and the green quantum dots in the color filter to emit red light (wavelength in a range of 620 nm ~ 780 nm) and green light (wavelength in a range of 500 nm ~ 560 nm), to achieve full color display.

SUMMARY

At least one embodiment of the present disclosure provides a color filter structure, and the color filter structure includes: a plurality of color control units on a substrate, and a pixel definition layer defining the plurality of color control units, in which the plurality of color control units are respectively defined in a plurality of openings divided by the pixel definition layer; the pixel definition layer comprises a plurality of spacers, each of the plurality of spacers separates two of the plurality of color control units from each other; an auxiliary part is on at least one side wall of at least one of the spacers that faces one of the color control units corresponding to the at least one of the spacers; compactability of the auxiliary part is greater than or equal to that of a bottom of the at least one of the spacers.

For example, in the color filter structure provided by at least one embodiment of the present disclosure, the compactability of the auxiliary part is greater than or equal to compactability of a surface of the at least one of the spacers in contact with an adjacent layer which is adjacent to the at least one of the spacers and is on a side close to the substrate.

For example, in the color filter structure provided by at least one embodiment of the present disclosure, the auxiliary part is in contact with a first surface of its adjacent layer at a side close to the substrate, and the at least one of the spacers is in contact with a second surface of its adjacent layer at the side close to the substrate; the first surface and the second surface are a same surface; or, a plane where the first surface is located and a plane where the second surface is located are different planes parallel to each other.

For example, in the color filter structure provided by at least one embodiment of the present disclosure, the auxiliary part has a third surface in contact with the first surface and a fourth surface in contact with the at least one of the spacers; a contour of the third surface is complementary to a contour of the first surface, and a contour of the fourth surface is complementary to a contour of a position that the fourth surface is in contact with the at least one of the spacers; and the third surface and the fourth surface are in contact with each other at a junction of the first surface and the at least one side wall of the at least one of the spacers, and the auxiliary part has a fifth surface in contact with the one of the color control units corresponding to the at least one of the spacers.

For example, in the color filter structure provided by at least one embodiment of the present disclosure, the auxiliary part has a first cross-section in a direction perpendicular to a main surface of the substrate, and a first cut-off line segment of the first cross-section is obtained by intercepting in a direction from a position away from the first surface to a position close to the first surface, a length of the first cut-off line segment is negatively related to a distance from the first cut-off line segment to the first surface.

For example, in the color filter structure provided by at least one embodiment of the present disclosure, the auxiliary part has a first cross-section in a direction perpendicular to a main surface of the substrate, and a first cut-off line segment of the first cross-section is obtained in a direction from a position away from the first surface to a position close to the first surface, a length of the first cut-off line segment gradually decreases with increase of a distance from the first cut-off line segment to the first surface.

For example, in the color filter structure provided by at least one embodiment of the present disclosure, in a shape of the first cross section of the auxiliary part in the direction perpendicular to the main surface of the substrate, the fifth surface has a corresponding first cut-off contour line, and the first cut-off contour line is one selected from a group consisting of a straight line segment, a curved line segment or a Z-shaped line.

For example, in the color filter structure provided by at least one embodiment of the present disclosure, in a case where the first cut-out contour line is the curved line segment, the curved line segment is recessed toward inside of the auxiliary part.

For example, in the color filter structure provided by at least one embodiment of the present disclosure, the spacer has a second cross-section in a direction perpendicular to a main surface of the substrate, with a straight line which is parallel to the substrate and passes through a farthest point away from the substrate of a shape of the second cross-section as a first boundary, and with a straight line formed by connecting two contact ends, of positions of the shape of the second cross-section where the second cross-section is in contact with the first surface, that are closest to the color control units as a second boundary, and with straight lines which respectively pass through the two contact ends and extend to the first boundary and circumscribe the shape of the second cross-section as a third boundary and a fourth boundary, in a quadrilateral surrounded by the first boundary, the second boundary, the third boundary and the fourth boundary, a line segment of the quadrilateral intercepted at the first boundary is a first side line, a line segment of the quadrilateral intercepted at the second boundary is a second side line, a line segment of the quadrilateral intercepted at the third boundary is a third side line, a line segment of the quadrilateral intercepted at the fourth boundary is a fourth side line, in which a length of the first side line is greater than a length of the second side line.

For example, in the color filter structure provided by at least one embodiment of the present disclosure, the length of the first side line is equal to 1.2 to 4 times the length of the second side line.

For example, in the color filter structure provided by at least one embodiment of the present disclosure, a maximum thickness of the auxiliary part in a direction perpendicular to a main surface of the substrate is greater than or equal to half of a thickness of a part of the spacer that is higher than the first surface and less than the thickness of the part of the spacer that is higher than the first surface.

For example, in the color filter structure provided by at least one embodiment of the present disclosure, the auxiliary part is an opaque structure.

For example, in the color filter structure provided by at least one embodiment of the present disclosure, the auxiliary part is made of a material of at least one selected from a group consisting of a black resin material and a metal material.

For example, in the color filter structure provided by at least one embodiment of the present disclosure, the metal material comprises one or more selected from a group consisting of gold, silver, aluminum, copper and molybdenum.

For example, in the color filter structure provided by at least one embodiment of the present disclosure, the auxiliary part is a light-transmissive structure.

For example, in the color filter structure provided by at least one embodiment of the present disclosure, the auxiliary part comprises a light-transmissive first basic substance and first scatter particles, and the first scatter particles are distributed in the first basic substance.

For example, in the color filter structure provided by at least one embodiment of the present disclosure, the first basic substance comprises a transparent resin; a material of the first scatter particles comprises a transparent metal oxide.

For example, in the color filter structure provided by at least one embodiment of the present disclosure, the color control units comprise a first color control unit, and the openings comprise a first opening, and the first color control unit is defined in the first opening divided by the pixel definition layer; and the first color control unit comprises color conversion particles, and the color conversion particles are configured to convert light with a first wavelength into light with a second wavelength.

For example, in the color filter structure provided by at least one embodiment of the present disclosure, the color conversion particles comprise a red quantum dot or a green quantum dot.

For example, in the color filter structure provided by at least one embodiment of the present disclosure, the color control units further comprise a second color control unit, and the openings further comprise a second opening, and the second color control unit is defined in the second opening divided by the pixel definition layer; the second color control unit is configured to transmit light with the first wavelength entering the second color control unit with the first wavelength.

For example, in the color filter structure provided by at least one embodiment of the present disclosure, the second color control unit comprises a light-transmissive second basic substance; and the second color control unit comprises second scatter particles distributed in the second basic substance.

For example, in the color filter structure provided by at least one embodiment of the present disclosure, the second basic substance comprises a transparent resin, and a material of the second scatter particles comprises a transparent metal oxide.

For example, in the color filter structure provided by at least one embodiment of the present disclosure, the first basic substance is the same as the second basic substance.

For example, in the color filter structure provided by at least one embodiment of the present disclosure, a material of the auxiliary part adjacent to the second color control unit comprises the first scatter particles dispersed in the first basic substance, a material of the first scatter particles is same as that of the second scatter particles, and a mass percentage of the second scatter particles in the second color control unit is smaller than that of the first scatter particles in the auxiliary part adjacent to the second color control unit.

For example, in the color filter structure provided by at least one embodiment of the present disclosure, the second opening is disposed adjacent to at least one of the first openings.

For example, in the color filter structure provided by at least one embodiment of the present disclosure, the auxiliary part in the first opening is a first auxiliary part, and the auxiliary part in the second opening is a second auxiliary part, both the first auxiliary part and the second auxiliary part comprise the first basic substance and the first scatter particles dispersed in the first basic substance, and a mass percentage of the first scatter particles in the first auxiliary part is less than a mass percentage of the first scatter particles in the second auxiliary part.

For example, in the color filter structure provided by at least one embodiment of the present disclosure, in a case where the auxiliary part is in the first opening, a refractive index of the auxiliary part is smaller than that of the first color control unit.

For example, in the color filter structure provided by at least one embodiment of the present disclosure, in a case where the auxiliary part is only in the first opening, a refractive index of the auxiliary part is smaller than that of the first color control unit; in a case where the auxiliary part is only in the second opening, the refractive index of the auxiliary part is larger than that of the second color control unit; in a case where the auxiliary part is in both the first opening and the second opening, the refractive index of the auxiliary part in the first opening is less than or equal to that of the first color control unit, and the refractive index of the auxiliary part in the second opening is greater than that of the second color control unit, or, the refractive index of the auxiliary part in the first opening is smaller than that of the first color control unit, and the refractive index of the auxiliary part in the second opening is equal to that of the second color control unit.

For example, in the color filter structure provided by at least one embodiment of the present disclosure, the first auxiliary part and the second auxiliary part each comprise only the first basic substance.

For example, in the color filter structure provided by at least one embodiment of the present disclosure, a contact angle of the spacers with propylene glycol methyl ether acetate is greater than or equal to 40 degrees, and a contact angle of the auxiliary part with water is less than or equal to 20 degrees.

For example, in the color filter structure provided by at least one embodiment of the present disclosure, a contact angle of the spacers with water is greater than or equal to 90 degrees, and a contact angle of the auxiliary part with water is less than or equal to 50 degrees.

For example, in the color filter structure provided by at least one embodiment of the present disclosure, a material of the spacers comprises heat curable resin.

For example, in the color filter structure provided by at least one embodiment of the present disclosure, the plurality of spacers are distributed in an array; along a row direction, one of the at least one side wall of each of the spacers is provided with the auxiliary part; along a column direction, one of the at least one side wall of each of the spacers is provided with the auxiliary part.

For example, in the color filter structure provided by at least one embodiment of the present disclosure, the plurality of spacers are distributed in an array, along the row direction, the auxiliary parts are respectively on two opposite side walls of a same spacer of the plurality of spacers, or, the auxiliary parts are respectively on the side walls closest to each other of two adjacent spacers of the plurality of spacers; along the column direction, the auxiliary parts are respectively on two opposite side walls of a same spacer of the plurality of spacers, or the auxiliary parts are respectively on the side walls closest to each other of two adjacent spacers of the plurality of spacers.

For example, in the color filter structure provided by at least one embodiment of the present disclosure, in a case where the auxiliary parts are respectively on the side walls closest to each other of two adjacent spacers of the plurality of spacers, the auxiliary parts, respectively on the side walls closest to each other of the two adjacent spacers, are connected or disconnected with each other.

For example, in the color filter structure provided by at least one embodiment of the present disclosure, the plurality of spacers are distributed in an array, and the spacers comprise first spacers and second spacers which are adjacent to each other and alternately arranged, along a row direction, both two opposite side walls of the at least one side wall of the first spacer are provided with the auxiliary parts, and both two opposite side walls of the at least one side wall of the second spacer are not provided with the auxiliary part; and along the column direction, both two opposite side walls of the at least one side wall of the first spacer are provided with the auxiliary parts, and both two adjacent side walls of the at least one side wall of the second spacer are not provided with the auxiliary part.

For example, in the color filter structure provided by at least one embodiment of the present disclosure, the plurality of spacers are distributed in an array, along the row direction, the auxiliary parts are on two opposite side walls of the at least one side wall of each of the plurality of spacers, and the auxiliary parts, on the side walls closest to each other of two adjacent spacers of the plurality of spacers, are connected or disconnected with each other; and along the column direction, the auxiliary parts are on two opposite side walls of the at least one side wall of each of the plurality of spacers, and the auxiliary parts, on the side walls closest to each other of two adjacent spacers of the plurality of spacers, are connected or disconnected with each other.

At least one embodiment of the present disclosure further provides a display panel, and the display panel comprises any one of the color filter structures mentioned above, a plurality of light-emitting units on a base substrate, and the color control units are on a side of the plurality of light-emitting units away from the base substrate, and light emitted by the plurality of light-emitting units is emitted through the plurality of color control units.

For example, the display panel provided by at least one embodiment of the present disclosure further comprises sub-pixels arranged in an array, in which the sub-pixels arranged in the array comprise a first sub-pixel, a second sub-pixel and a third sub-pixel, each selected from a group consisting of the first sub-pixel, the second sub-pixel and the third sub-pixel comprises one of the light-emitting units and one of the color filter structure, and the one of the light-emitting units and the one of the color filter structure are laminated; the display panel further comprises a light-emitting unit definition layer, in which the light-emitting unit definition layer comprises a plurality of pixel openings, the plurality of light-emitting units are in the pixel openings in one-to-one correspondence, and an orthographic projection of each of the pixel openings is in an orthographic projection of one of the openings corresponding to the each of the pixel openings; the display panel further comprises an isolation layer, wherein the plurality of the light-emitting units are spaced apart from the color filter structure by the isolation layer, and the color filter structure is directly on the isolation layer.

For example, in the display panel provided by at least one embodiment of the present disclosure, a side of the isolation layer away from the base substrate has an isolation layer opening area, and at least a part of at least one of the spacers is in the isolation layer opening area.

For example, in the display panel provided by at least one embodiment of the present disclosure, light-emitting elements corresponding to the light-emitting units are organic light-emitting diode devices.

For example, in the display panel provided by at least one embodiment of the present disclosure, the first sub-pixel, the second sub-pixel and the third sub-pixel are respectively a red sub-pixel, a green sub-pixel and a blue sub-pixel, the color control unit in the red sub-pixel comprises a red quantum dot, the color control unit in the green sub-pixel comprises a green quantum dot, and the color control unit in the blue sub-pixel comprises at least one of a transparent resin and a blue quantum dot.

For example, in the display panel provided by at least one embodiment of the present disclosure, light emitted by the light-emitting elements is blue light.

At least one embodiment of the present disclosure further provides a preparation method of a color filter structure, and the preparation method includes: providing a substrate; forming a plurality of color control units and a pixel definition layer defining the plurality of color control units on the substrate, in which the plurality of color control units are respectively defined in a plurality of openings divided by the pixel definition layer; the pixel definition layer comprises a plurality of spacers, each of the plurality of spacers separates two of the plurality of color control units from each other; an auxiliary part is formed on at least one side wall of at least one of the spacers that faces the color control unit; compactability of the auxiliary part is greater than or equal to that of a bottom of the at least one of the spacers.

For example, in the preparation method provided by at least one embodiment of the present disclosure, the compactability of the auxiliary part is greater than or equal to compactability of a surface of the at least one of the spacers in contact with an adjacent layer which is adjacent to the at least one of the spacers and is on a side close to the substrate.

For example, in the preparation method provided by at least one embodiment of the present disclosure, the auxiliary part comprises a light-transmissive first basic substance.

For example, in the preparation method provided by at least one embodiment of the present disclosure, the color control units comprise a first color control unit, and the openings comprise a first opening, and the first color control unit is defined in the first opening divided by the pixel definition layer; the first color control unit comprises color conversion particles, and the color conversion particles are configured to convert light with a first wavelength into light with a second wavelength.

For example, in the preparation method provided by at least one embodiment of the present disclosure, the color control units further comprise a second color control unit, and the openings further comprise a second opening, and the second color control unit is defined in the second opening divided by the pixel definition layer; the second color control unit is configured to transmit light with the first wavelength entering the second color control unit with the first wavelength; and the second color control unit comprises a light-transmissive second basic substance.

For example, in the preparation method provided by at least one embodiment of the present disclosure, the second color control unit comprises second scatter particles, and the second scatter particles are distributed in the second basic substance; the first basic substance is same as the second basic substance.

For example, in the preparation method provided by at least one embodiment of the present disclosure, a material of the auxiliary part adjacent to the second color control unit comprises the first scatter particles dispersed in the first basic substance, a material of the first scatter particles is same as that of the second scatter particles, and a mass percentage of the second scatter particles in the second color control unit is smaller than that of the first scatter particles in the auxiliary part adjacent to the second color control unit.

For example, in the preparation method provided by at least one embodiment of the present disclosure, the first auxiliary part and the second auxiliary part are formed in a same process step, and forming the first auxiliary part and the second auxiliary part comprises: forming a first ink comprising an uncured first basic substance and the first scatter particles in the plurality of the second openings, allowing at least a part of components in the first ink to permeate through at least one of the spacers to reach at least one of the first openings to form a second ink, wherein remaining components in the first ink form a third ink; and curing the second ink and the third ink to form the first auxiliary part on the side wall of the at least one spacer, which defines the at least one first opening, close to the at least one first opening, and to form the second auxiliary parts in the plurality of second openings.

For example, in the preparation method provided by at least one embodiment of the present disclosure, the first auxiliary part and the second color control unit are formed in a same process step, and forming the first auxiliary part and the second color control unit comprises: forming a first ink comprising an uncured first basic substance and first scatter particles in the plurality of the second openings; allowing at least a part of components in the first ink to permeate through at least one of the spacers to reach at least one of the first openings to form a second ink, and remaining components in the first ink form a third ink; and curing the second ink and the third ink to form the first auxiliary part on the side wall, of the at least one spacer defining the at least one first opening, that is close to the at least one first opening, and to form the second color control units in the plurality of second openings.

For example, in the preparation method provided by at least one embodiment of the present disclosure, the second color control units and the auxiliary parts in the plurality of second openings are formed in a same process step, and forming the second color control units and the auxiliary parts comprises: forming an auxiliary layer ink in at least a part of the first openings, and forming a second color control ink in the plurality of the second openings; and curing the auxiliary layer ink and the second color control ink to form the auxiliary parts on the side walls of the at least one spacer, which defines the at least one first opening, close to the corresponding first opening, and forming the second color control units in a plurality of second openings.

For example, in the preparation method provided by at least one embodiment of the present disclosure, the first auxiliary part and the second auxiliary part are formed in a same process step, and forming the first auxiliary part and the second auxiliary part comprises: forming a first ink comprising an uncured first basic substance and first scatter particles in the plurality of the first openings; allowing at least a part of components in the first ink to permeate through at least one of the spacers to reach at least one of the second openings to form a second ink, and remaining components in the first ink form a third ink; and curing the second ink and the third ink to form the second auxiliary part on the side wall of the at least one spacer, which defines the at least one second opening, close to the at least one second opening, and to form the first auxiliary parts in the plurality of the first openings.

For example, in the preparation method provided by at least one embodiment of the present disclosure, a material of the spacer is heat curable resin, a material of the auxiliary part is ultraviolet curable resin, and the auxiliary part is formed by inkjet printing.

For example, in the preparation method provided by at least one embodiment of the present disclosure, a process of forming the auxiliary part by inkjet printing comprises: forming the ultraviolet curable resin in the opening, performing an ultraviolet curing process on the material of the auxiliary part after pre-infiltration to form the auxiliary part, and before the pre-infiltration, a volume of the ultraviolet curable resin is 90% to 120% of an accommodating space of the opening.

For example, in the preparation method provided by at least one embodiment of the present disclosure, the ultraviolet curable resin is a resin material containing nanoparticles, a viscosity of the ultraviolet curable resin at room temperature is in a range of 5 cps to 12cps, and a surface tension of the ultraviolet curable resin is in a range of 30 mN/m to 35 mN/m.

For example, in the preparation method provided by at least one embodiment of the present disclosure, a material of the spacer is heat curable resin, a material of the auxiliary part is titanium oxide or silicon oxide, the auxiliary part is formed by a photolithography process, and the auxiliary part is formed before or after the spacer is formed.

BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the present disclosure and thus are not limitative of the present disclosure.

FIG 1 is a schematic stereoscopic structural diagram of a color filter structure provided by an embodiment of the present disclosure;
FIG 2 is a schematic cross-sectional view of the color filter structure in FIG 1 taken along the line A-A';
FIG 3 is a schematic cross-sectional view of a color filter structure provided by another embodiment of the present disclosure;
FIG 4 is a schematic cross-sectional view of a color filter structure provided by still another embodiment of the present disclosure;
FIG 5 is a scanning electron microscope diagram of a spacer provided by an embodiment of the present disclosure;
FIG 6 is a schematic cross-sectional view of an auxiliary part in FIG 4;
FIG 7 is a schematic cross-sectional structure of an auxiliary part provided by an embodiment of the present disclosure;
FIG 8 is a schematic cross-sectional view of a color filter structure provided by still another embodiment of the present disclosure;

FIG 9 is a schematic cross-sectional view of a color filter structure provided by still another embodiment of the present disclosure;

FIG 10 is a schematic cross-sectional structure diagram of a color filter structure provided by still another embodiment of the present disclosure;

FIG 11 is a schematic cross-sectional structure diagram of a color filter structure provided by still another embodiment of the present disclosure;

FIG 12 is a schematic cross-sectional structure diagram of a color filter structure provided by still another embodiment of the present disclosure;

FIG 13 is a schematic cross-sectional structure diagram of a color filter structure provided by still another embodiment of the present disclosure;

FIG 14 is a schematic cross-sectional structure diagram of a color filter structure provided by still another embodiment of the present disclosure;

FIG 15 is a schematic cross-sectional structure diagram of a color filter structure provided by still another embodiment of the present disclosure;

FIG 16 is a schematic cross-sectional structure diagram of a color filter structure provided by still another embodiment of the present disclosure;

FIG 17 is a schematic cross-sectional structure diagram of a color filter structure provided by still another embodiment of the present disclosure;

FIG. 18 is a schematic diagram of a light ray with a first wavelength gathered in a second opening and a light ray with a second wavelength dispersed in a first opening provided by an embodiment of the present disclosure;

FIG. 19 is a schematic planar view of the arrangement of spacers and auxiliary parts in a color filter structure provided by an embodiment of the present disclosure;

FIG. 20 is a schematic planar view of the arrangement of spacers and auxiliary parts in another color filter structure provided by an embodiment of the present disclosure;

FIG. 21 is a schematic planar view of the arrangement of spacers and auxiliary parts in still another color filter structure provided by an embodiment of the present disclosure;

FIG. 22 is a schematic planar view of the arrangement of spacers and auxiliary parts in still another color filter structure provided by an embodiment of the present disclosure;

FIG. 23 is a schematic planar view of the arrangement of spacers and auxiliary parts in still another color filter structure provided by an embodiment of the present disclosure;

FIG. 24 is a schematic planar view of the arrangement of spacers and auxiliary parts in still another color filter structure provided by an embodiment of the present disclosure;

FIG. 25 is a schematic planar view of the arrangement of spacers and auxiliary parts in still another color filter structure provided by an embodiment of the present disclosure;

FIG. 26 is a planar view of distribution of the pixel control unitsof a color filter provided by an embodiment of the present disclosure;

FIG. 27 is a schematic cross-sectional view of the color filter structure in FIG. 26 by taking along line B-B';

FIG. 28 is a planar view of distribution of the pixel control units of a color filter provided by another embodiment of the present disclosure;

FIG. 29 is a planar view of distribution of the pixel control units of a color filter provided by still another embodiment of the present disclosure;

FIG. 30 is a planar view of distribution of the pixel control units of a color filter provided by still another embodiment of the present disclosure;

FIG. 31 is a scanning electron microscope diagram including a spacer and an auxiliary part provided by an embodiment of the present disclosure;

FIG. 32 is another scanning electron microscope diagram including a spacer and an auxiliary part provided by an embodiment of the present disclosure;

FIG. 33 is a stereoscopic view of a display panel provided by an embodiment of the present disclosure;

FIG. 34 is a schematic cross-sectional view of the display panel in FIG. 33 taken along the line A-A';

FIG. 35 is a schematic cross-sectional structure diagram of another display panel provided by an embodiment of the present disclosure;

FIG. 36 is a schematic cross-sectional structure diagram of another display panel provided by an embodiment of the present disclosure;

FIG. 37 is a flowchart of a preparation method of the color filter structure provided by an embodiment of the present disclosure;

FIG. 38 is a flowchart of forming a first auxiliary part and a second auxiliary part provided by an embodiment of the present disclosure;

FIG. 39A to FIG. 39C are process diagrams of forming a first auxiliary part and a second auxiliary part provided by an embodiment of the present disclosure;

FIG. 40 is another flowchart of forming a first auxiliary part and a second auxiliary part provided by an embodiment of the present disclosure;

FIG. 41A to FIG. 41C are process diagrams of forming a first auxiliary part and a second auxiliary part provided by an embodiment of the present disclosure;

FIG. 42 is a flowchart of forming a second color control unit and an auxiliary part provided by an embodiment of the present disclosure;

FIG. 43 is a flowchart of forming a second color control unit and an auxiliary part provided by another embodiment of the present disclosure;
FIG. 44A to FIG. 44B are diagrams of a process of forming an auxiliary part and a spacer provided by an embodiment of the present disclosure; and
FIG. 45A to FIG. 45I are process diagrams of preparing the display panel provided by an embodiment of the present disclosure.

DETAILED DESCRIPTION

In order to make objects, technical details and advantages of the embodiments of the present disclosure apparent, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment (s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. Also, the terms "comprise," "comprising," "comprise," "comprising," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may comprise an electrical connection, directly or indirectly. "On," "under," "left," "right" and the like are only used to indicate relative position relationship, and when the position of the object which is described is changed, the relative position relationship may be changed accordingly.

The preparation method of a quantum dot color filter mainly includes two kinds of process routes which are using quantum dots-photoresist (hereinafter referred to as QD-PR) and using quantum dots-ink (hereinafter referred to as QD-Ink). The process route of using QD-PR includes: dispersing quantum dots in photoresist to form quantum dot photoresist, then coating the quantum dot photoresist on the surface of the substrate, and forming a required color filter by the method of exposure and development. The process route of using QD-Ink includes: dispersing quantum dots in a suitable solvent to form ink, directly printing the quantum dot ink in each sub-pixel region of the substrate by printing, and drying and curing the ink to form the required color filter. Because the process route of QD-PR includes the steps of patterning, a mask is needed in the process of patterning, and it is difficult to form a color filter with very high pattern accuracy due to the limitation of the pattern accuracy of the mask, so it cannot meet the demand of high-resolution display. Therefore, the process route of using QD-Ink is usually adopted to prepare the quantum dot color filter.

The ink used in the QD-Ink process may be divided into two types: thermal curing ink and ultraviolet curing ink. The technology of thermal curing ink is relatively mature, and has a wider application range. In a stable thermal curing QD-Ink process, the solvent content ratio is very high (for example, up to more than 70%), and curing needs to be carried out in two steps. The first step is to dry the printed ink at a lower temperature to remove the solvent in the ink; the second step is to cure the dried ink at a higher temperature, so that the unsaturated monomers in the ink components have a cross-linking reaction and are cured to form a film.

After the ink is cured and molded, it is necessary for the film to have a certain film thickness (usually in a range of $6\mu m \sim 8\mu m$) to reduce the transmittance of QD-CF to the light with the first wavelength (for example, blue light) emitted by the backlight and improve the color purity, so that the light with the first wavelength emitted by the backlight can fully illuminate the quantum dots in the film to excite the quantum dots to emit corresponding light. QD-Ink is usually printed and dried for many times, or cured at one time at a high temperature or cured by ultraviolet light.

There are two ways to integrate the structure of quantum dots with organic electroluminescent diodes (QD-OLED): the way of bonding a box and the way of color filter layer on the light-emitting element (COE). In the preparation process of QD-OLED structure in the COE mode, because the heat-resistant temperature of the organic functional layer in the OLED device is below 100°C, the pixel definition layer needs to be cured below 100°C, and the printing quantum dots also require that the spacer included in the pixel definition layer has a lyophobicity. The curing temperature of the material of the pixel definition layer meeting the lyophobic requirement is usually 230°C. When the pixel definition layer is cured below 100°C, the lyophobicity of the top of the spacer included in the pixel definition layer can meet the printing requirements, but because of the low curing temperature, the curing rate at the bottom of the spacer included in the pixel definition layer is insufficient, resulting in poor compactability, and the phenomenon that quantum dot ink in one pixel region penetrates into the adjacent pixel region occurs. For example, the printed red quantum dot ink permeates into the green quantum dots, which leads to the phenomenon of cross-color, which further affects the display effect and reduces the color gamut. In addition, insufficient curing rate of the bottom of the spacer included in the pixel definition layer can easily lead to the problem that the pixel definition layer is easy to be peeled off from the substrate, and the swelling of the pixel definition layer with a low curing rate can also lead to the phenomenon of quantum dot ink penetration.

The inventors of the present disclosure notice that an auxiliary part may be arranged on a side wall of the spacer of the pixel definition layer, and the compactability of the auxiliary part is greater than or equal to that of the bottom of the spacer, so as to reduce or eliminate the phenomenon that printing ink in one pixel region penetrates into the adjacent pixel region, thereby reducing the phenomenon of cross-color and ensuring a higher color gamut.

At least one embodiment of that present disclosure provides a color filter structure, the color filter structure comprises a substrate, a plurality of color control units on the substrate, and a pixel definition layer defining the plurality of color control units; the plurality of color control units are respectively defined in a plurality of openings divided by the pixel definition layer; the pixel definition layer comprises a plurality of spacers, each of the plurality of spacers separates two of the plurality of color control units from each other; an auxiliary part is on at least one side wall of at least one of the spacers that faces one of the color control units corresponding to the at least one of the spacers; compactability of the auxiliary part is greater than or equal to that of a bottom of the at least one of the spacers.

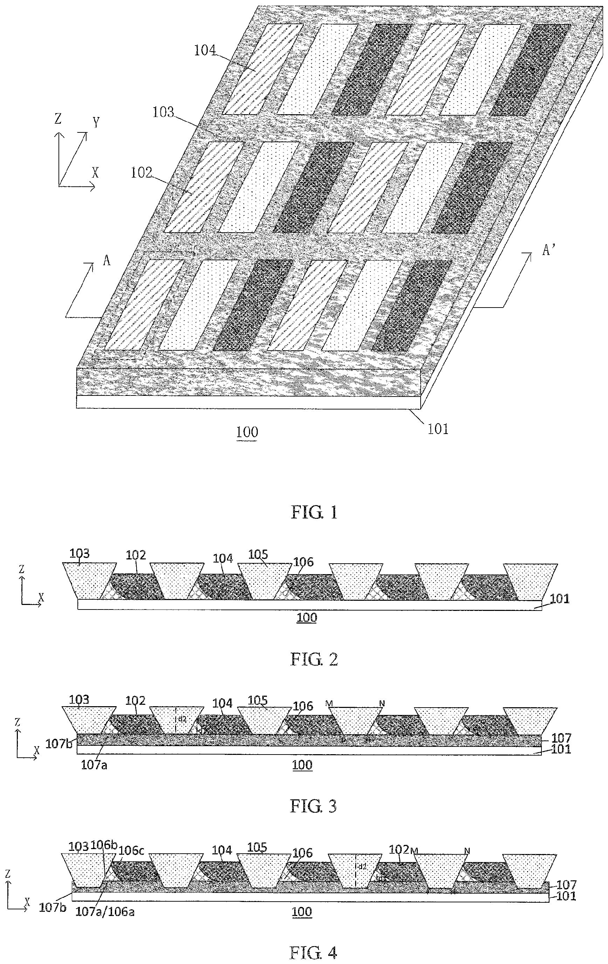

For example, FIG. 1 is a schematic stereoscopic structural diagram of a color filter structure provided by an embodiment of the present disclosure, as illustrated in FIG. 1, the color filter structure 100 comprises a substrate 101, a plurality of color control units 102 on the substrate 101, and a pixel definition layer 103 defining the plurality of color control units 102; the plurality of color control units 102 are respectively defined in a plurality of openings 104 divided by the pixel definition layer 103; the pixel definition layer 103 comprises a plurality of spacers 105, each of the plurality of spacers 105 separates two of the plurality of color control units 102 from each other; an auxiliary part (not shown in FIG. 1) is on at least one side wall of at least one of the spacers 105 that faces the color control unit 102; compactability of the auxiliary part is greater than or equal to that of a bottom of the at least one of the spacers 105.

For example, FIG. 2 is a schematic cross-sectional view of the color filter structure in FIG. 1 taken along line A-A', as illustrated in FIG. 2, the color filter structure 100 comprises the substrate 101, the plurality of color control units 102 on the substrate 101, and the pixel definition layer 103 defining the plurality of color control units 102; the plurality of color control units 102 are respectively defined in the plurality of openings 104 divided by the pixel definition layer 103; the pixel definition layer 103 comprises a plurality of spacers 105, each of the plurality of spacers 105 separates two of the plurality of color control units 102 from each other; an auxiliary part 106 is on at least one side wall of at least one of the spacers 105 that faces the color control unit 102; compactability of the auxiliary part 106 is greater than or equal to that of a bottom of the at least one of the spacers 105.

For example, in the structure shown in FIG. 2, the auxiliary part 106 is provided on one side wall of each spacer 105 that faces the color control unit 102. The embodiment of the present disclosure is not limited to this case, but the auxiliary part 106 may also be provided on one side wall of a part of the spacers 105 that faces the color control unit 102, the auxiliary parts 106 may also be provided on a plurality of side walls of a part of the spacers 105 that face the color control unit 102, and the auxiliary parts 106 may also be provided on a plurality of side walls of each spacer 105 that face the color control unit 102.

For example, the compactability of the auxiliary part 106 is greater than or equal to the compactability of the bottom of the spacer 105, which can be equivalent to improving the compactability of the bottom of the spacer 105, so that the ink in a flowing state in the subsequent can be prevented from penetrating into the adjacent openings, and thus cross-color can be avoided, and the influence on the display effect can be avoided.

For example, the spacer 105 needs to have a large contact angle, that is, the spacer 105 needs to have good lyophobicity, which can make it difficult for the ink to spread when it is applied, and make it easier for the applied ink to completely enter the corresponding opening 104 instead of flowing into other inappropriate openings 104. The auxiliary part 106 needs to have a small contact angle, that is, good lyophilicity, so that the applied ink can be easily spread in the corresponding opening 104. Therefore, the material of the auxiliary part 106 needs to meet the requirements of compactability and lyophilicity at the same time. It can be understood that the lyophilicity and lyophobicity of materials vary with different liquids. For the sake of production technology, the material of the spacer 105 is lyophobic to the ink used in production, and the material of the auxiliary part 106 is lyophilic to the ink used in production.

For example, the compactability of the auxiliary part 106 refers to the difficulty degree of liquid or gas penetrating through the auxiliary part 106, and the compactability of the spacer 105 refers to the difficulty degree of liquid or gas penetrating through the spacer 105. Because the density of different positions of the spacer 105 may be different, the density of the bottom of the spacer 105 refers to the difficulty degree of liquid or gas penetrating through the bottom of the spacer 105. Specifically, the color control unit is generally prepared by a fluid (e.g., ink) curing process. Therefore, the compactability of target positions (e.g., specific positions at the bottom of the spacer 105) of the auxiliary part 106 and the spacer 105 can be determined by the fluid permeability. The fluid permeability can be defined as the fluid mass per unit area passing through the target position in a unit time under certain temperature and humidity conditions. When testing the fluid permeability of the materials corresponding to the target positions of the auxiliary part 106 and the spacer 105, the same fluid should be selected. For example, the fluid may be water; for example, the fluid may be the ink used to prepare the color control unit, but it is not limited to these cases. During the test, other conditions remain the same except that the selected material having different compactability. The lower the fluid permeability, the better the compactability of the material. Therefore, in the embodiment of the present disclosure, the fluid permeability of the auxiliary part 106 is greater than or equal to that of the bottom of the spacer 105.

For example, the curing ratio is a quantitative parameter of the degree of chemical reaction of organic materials. In the case where the material of the spacer 105 is a polymer, the higher the curing ratio of the polymer, the less likely it is to penetrate ink, and the better the compactability. Therefore, the compactability of the target position can be judged by measuring the curing ratio of the target positions of the auxiliary part 106 and the spacer 105. For example, in the case where both the materials of the spacer 105 and the auxiliary part 106 are polymers, the curing ratio of the auxiliary part is greater than or equal to the curing ratio of the bottom of the spacer 106.

For example, the material of the auxiliary part 106 may be inorganic substance, and the material of the spacer 105 may be polymer. For example, the material of the auxiliary part 106 may include at least one selected from a group consisting of aluminum oxide, titanium oxide, tantalum oxide, hafnium oxide, zinc oxide, silicon oxide, silicon nitride and silicon oxynitride. In the case where the auxiliary part 106 is made of the inorganic materials as exemplified above, the compactability of the auxiliary part 106 is greater than that of the spacer 105. It can be understood that the inorganic substances used in the present disclosure to form the auxiliary part 106 are not limited to the above examples, and the density of the material can be specifically judged by comparing the fluid permeability of the auxiliary part 106 with that of the spacer 105.

For example, the process of inkjet printing is to make the quantum dot ink have a viscosity in a range of 5 cps to 10cps and a surface tension in a range of 30 mN/m to 35 mN/m at a temperature that the nozzle can heat, for example, below 50°C. The quantum dots were cured with energy (energy dose of ultraviolet light) of 2000mj. In the case where the curing energy is more than 2000mj, it may cause damage to light-emitting elements, such as OLED devices, and cause damage to a back plate.

For example, a basic substance material in the quantum dot ink is an ultraviolet curable resin, the ultraviolet curable resin is composed of resin monomer or oligomer, and the ultraviolet curable resin may include acrylate monomer, epoxy acrylate, polyurethane acrylate, polyester acrylate and acrylate with special functional groups.

For example, the auxiliary part 106 may be provided on only one side wall of the spacer 105, two opposite side walls of the spacer 105, or more side walls of the spacer 105.

For example, the material of the auxiliary part 106 is an ultraviolet curable resin, and the auxiliary part 106 made of the ultraviolet curable resin has strong compactability after being cured by ultraviolet light. In the case where the quantum dot ink is printed in the opening provided with the auxiliary part 106, the permeability of the quantum dot ink is less than 0.1%, and the transmittance of the auxiliary part 106 to visible light is at least greater than 90%.

For example, the material of the spacer 105 includes a resin with a light reflection function or a light absorption function, and the curing temperature of the spacer 105 is lower than 100°C. The material of the spacer 105 with the light reflection function includes at least one selected from a group consisting of acrylic resin, epoxy resin, polyimide and polyethylene mixed with light scatter particles, the light scatter particles may include at least one kind selected from a group consisting of titanium oxide particles and silicon oxide particles. The material of the spacer 105 with the light reflection function includes at least one selected from a group consisting of acrylic resin, epoxy resin, polyimide and polyethylene mixed with a light absorption function material, for example, the light absorption function material may include at least one selected from a group consisting of aniline black, perylene black, titanium black, carbon black or metal oxide with a light absorption function.

It should be noted that the compactability of the auxiliary part 106 is greater than that of the bottom of the spacer 105, and the compactability of the auxiliary part 106 is 1.1 times that of the bottom of the spacer 105, or, the compactability of the auxiliary part 106 is smaller than that of the bottom of the spacer 105, and the compactability of the auxiliary part 106 is 0.9 times that of the bottom of the spacer 105, all these cases can be considered as that the compactability of the auxiliary part 106 is equal to the compactability of the bottom of the spacer 105, that is, if a ratio of an absolute value of the difference between the compactability of the auxiliary part 106 and the compactability of the bottom of the spacer 105, and the compactability of the bottom of the spacer 105 is within 10% (i.e. within the range of 100% ± 10% of the compactability of the bottom of the spacer 105), it can be considered that the compactability of the auxiliary part 106 is equal to the compactability of the bottom of the spacer 105.

It should also be noted that the bottom includes a bottom surface and an area surrounded by a part of side surfaces connected with the bottom surface. Therefore, the meaning that the compactability of the auxiliary part 106 is greater than or equal to that of the bottom of the spacer 105 may include the case where the compactability of the auxiliary part 106 is greater than or equal to that of the bottom surface of the spacer 105 and that of the area surrounded by the part of side surfaces of the spacer 105 connected with the bottom surface. For example, in one example, the part of the side surfaces is the side surface defined by 5%, 10%, 20%, 25%, 30%, 35% or 40% of the thickness of the entire spacer 105, that is, 5%, 10%, 20% or 25% of the height extending from the substrate 101 to a positon away from the base 101 in the thickness direction of the spacer 105. For example, in the case where the thickness of the spacer 105 is in the range of 8 microns to 22 microns, the thickness of the bottom of the spacer 105 may be 4 microns, 2 microns, 1 micron or 0.5 microns.

For example, FIG. 3 a schematic cross-sectional view of a color filter structure provided by another embodiment of the present disclosure. As shown in FIG. 3, the compactability of the auxiliary part 106 is greater than or equal to the compactability of the surface of the spacer 105 that is in contact with an adjacent layer 107 on one side of the substrate 101.

For example, the adjacent layer 107 may be an insulation layer, an encapsulation layer and so on. In one example, the adjacent layer 107 may be the substrate 101, which is not limited to these cases by the embodiments of the present disclosure.

For example, as shown in FIG. 3, the auxiliary part 106 is in contact with the first surface 107a of the adjacent layer 107 on the side of the substrate 101, and the spacer 105 is in contact with the second surface 107b of the adjacent layer 107 on the side of the substrate 101, and the first surface 107a is the same surface as the second surface 107b. It should be noted here that the adjacent layer 107 does not specifically refer to a specific layer structure, but the film in contact with the spacer 105 is the adjacent layer. For example, the adjacent layer may be different layer structures in different examples.

For example, FIG. 4 is a schematic cross-sectional view of a color filter structure provided by still another embodiment of the present disclosure. As shown in FIG. 4, for a part of the auxiliary parts 106, the auxiliary part 106 contacts with the first surface 107a of the adjacent layer 107 on the side of the substrate 101, and the spacer 105 contacts the second surface 107b of the adjacent layer 107 on the side of the substrate 101. The plane where the first surface 107a is located and the plane where the second surface 107b is located are parallel to each other, that is, in FIG. 4, the plane where the first surface 107a is located is farther away from the substrate 101 than the plane where the second surface 107b is located. It is worth noting that the above descriptions of the present disclosure are all based on ideal flat shapes, and in the actual production, the above surfaces may not be ideal flat surfaces. However, these surfaces should not have excessive undulations. In the case that these surfaces have only a small fluctuation relative to the ideal shape, the plane is determined by fitting its surface to a flat surface.

For example, in the structure shown in FIG. 4, the spacer 105 may contact both the first surface 107a and the second surface 107b, that is, the plane where the second surface 107b is located is between the plane where the first surface 107a is located and the plane where the side surface of the substrate 101 close to the spacer 105 is located, so that the pixel definition layer 103 can be more stably arranged on the substrate 101, and the risk of the peeling of the pixel definition layer 103 from the substrate 101 can be reduced or avoided.

For example, as shown in FIG. 4, the auxiliary part 106 has a third surface 106a in contact with the first surface 107a, and a fourth surface 106b in contact with the spacer 105. A contour of the third surface 106a is complementary to a contour of the first surface 107a, and a contour of the fourth surface 106b is complementary to a part of the contour of the spacer that is in a position where the fourth surface is in contact with the spacer 105. The third surface 106a and the fourth surface 106b are in contact with each other at a junction of the first surface 107a and the side wall of the spacer 105, and the combined shape of the third surface 106a and the fourth surface 106b constitutes the shape of the contour of the auxiliary part 106 that contacts the spacer 105 and the auxiliary part 106.

It should be noted that the contour of the third surface 106a is complementary to the contour of the first surface 107a, means that the third surface 106a and the first surface 107a are completely attached to each other without any gap, and the contour of the third surface 106a is conformal with the contour of the first surface 107a.

For example, as shown in FIG. 4, the auxiliary part 106 has a fifth surface 106c that is in contact with the color control unit 102. A shape of an outer contour of the fifth surface 106c is a curved segment, and the curved segment is depressed to the side away from the color control unit 102, so that a shape of the overall outer contour of the auxiliary part 106 is triangular-like with one side depressed to the side away from the color control unit 102.

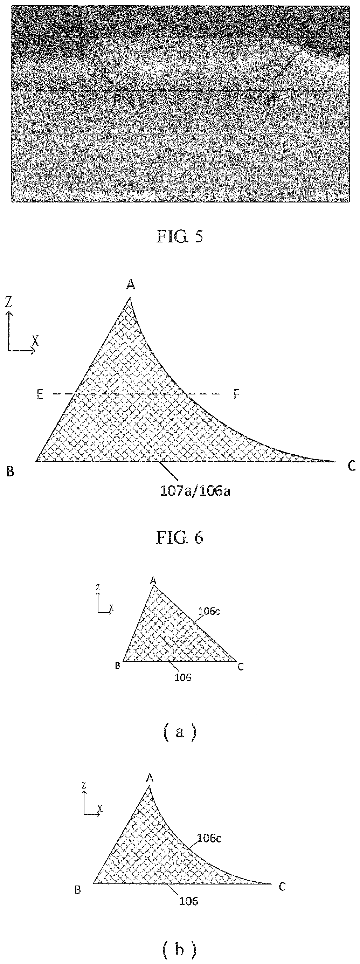

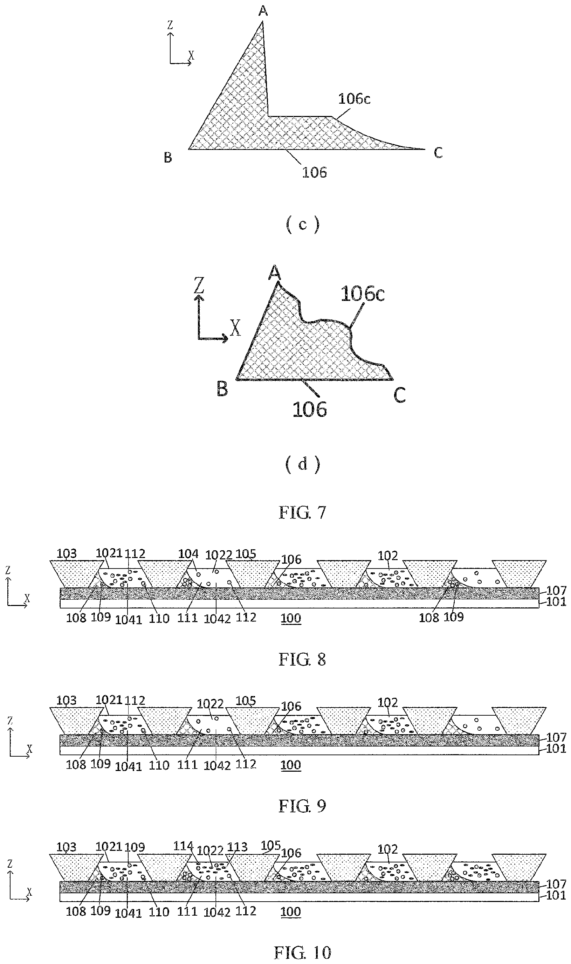

For example, FIG. 6 is a schematic cross-sectional view of an auxiliary part in FIG. 4. As shown in FIG. 4 and FIG. 6, the auxiliary part 106 has a first cross-section ABC in the direction perpendicular to the main surface of the substrate 101, and when a first cut-off line segment EF of the first cross-section ABC is obtained by intercepting in the direction from a position away from the first surface 107a to a position close to the first surface 107a, the length of the first cut-off line segment EF is negatively related to a distance from the first cut-off line segment EF to the first surface 107a.

For example, as shown in FIG. 6, the auxiliary part 106 has a first cross-section ABC in the direction perpendicular to the main surface of the substrate 101, and when a first cut-off line segment EF of the first cross-section ABC is obtained by intercepting in the direction from a position away from the first surface 107a to a position close to the first surface 107a, the length of the first cut-off line segment EF gradually decreases with the increase of a distance from the first cut-off line segment EF to the first surface 107a.

For example, as shown in FIG. 6, from the direction from a position away from the first surface107a to a position close to the first surface 107a, the length of the first cut-off line segment EF of the first cross-section ABC gradually increases, and the distance from the first cut-off line segment EF to the first surface 107a gradually decreases.

It should be noted that the main surface of the substrate 101 is the surface on which the color control unit 102, the pixel definition layer 103, the spacers 105 and the auxiliary part 106 are disposed.

For example, FIG. 7 is a schematic cross-sectional structure of an auxiliary part provided by an embodiment of the present disclosure. As shown in FIG. 4 and FIG. 7, in the shape of the first cross-section ABC of the auxiliary part 106 in the direction perpendicular to the main surface of the substrate 101, the fifth surface 106c has a corresponding first cut-off contour line AC. In (a) of FIG. 7, the first cut-off contour line AC is a straight line segment; in (b) of FIG. 7, the first cut-off contour line AC is a curve segment; in (c) of FIG. 7, the first cut-off contour line AC is a Z-shaped line. In the case where the first cut-off contour line AC is a Z-shaped line, the length of the first cut-off line segment EF is not strictly gradually reduced with the increase of the distance from the first cut-off line segment EF to the first surface 107a, but it can be considered that the length of the first cut-off line segment EF is negatively related to the distance from the first cut-off line segment EF to the first surface 107a. For example, in (d) of FIG. 7, the first cut-off contour line AC is in a stepped shape, which can also be considered as a kind of Z-shaped line, and in the case where the first cut-off contour line AC is a Z-shaped line, the length of the first cut-off line segment EF is not strictly gradually reduced with the increase of the distance from the first cut-off line segment EF to the first surface 107a, but it can be considered that the length of the first cut-off line segment EF is negatively related to the distance from the first cut-off line segment EF to the first surface 107a. The shape of the first cut-off contour line AC may be in other suitable shapes, which is not limited in the embodiments of the present disclosure.

For example, as shown in FIG. 6 and (b) of FIG. 7, in a case that the first cut-off contour line AC is a curved segment, the curved segment AC is recessed toward the inside of the auxiliary part 106, and the first cut-off contour line AC provided by this curved segment can be obtained according to a specific preparation process, and the concave of the curved segment AC toward the inside of the auxiliary part 106 can reduce the space occupied by the auxiliary part and reserve more space for the color control units 102.

For example, as shown in FIG. 3 and FIG. 4, the spacer 105 has a second cross-section MNHP in the direction perpendicular to the main surface of the substrate 101, with a straight line which is parallel to the substrate 101 and passes through a farthest point away from the substrate 101 of a shape of the second cross-section MNHP as a first boundary MN, and with a straight line formed by connecting two contact ends P and H, of positions of the shape of the second cross-section MNHP where the second cross-section MNHP is in contact with the first surface 107a, that are closest to the color control unit 102 as a second boundary PH, and with straight lines which respectively pass through the two contact ends P and H and extend to the first boundary MN and circumscribe the shape of the second cross-section MNHP as a third boundary MP and a fourth boundary NH, in the quadrilateral MNHP surrounded by the first boundary MN, the second boundary PH, the third boundary MP and the fourth boundary NH, a line segment of the quadrilateral MNHP intercepted at the first boundary MN is a first side line MN, a line segment of the quadrilateral MNHP intercepted at the second boundary PH is a second side line PH, a line segment of the quadrilateral MNHP intercepted at the third boundary MP is a third side line MP, a line segment of the quadrilateral MNHP intercepted at the fourth boundary NH is a fourth side line NH, and the length of the first side line MN is greater than the length of the second side line PH. For example, in FIG. 3 and FIG. 4, the planar shape of the formed second cross-section MNHP is an inverted trapezoid. For example, FIG. 5 a scanning electron microscope diagram of a spacer provided by an embodiment of the present disclosure. As shown in FIG. 5, the cross-sectional shape of the spacer 105 is an inverted trapezoid as shown by the second cross-section MNHP. It should be noted that the planar shape of the second cross-section MNHP in the embodiment of the present disclosure is not limited to the inverted trapezoid in FIG. 3 and FIG. 4, but may be other suitable shapes.

For example, the length of the first side line MN of the quadrilateral MNHP is equal to 1.2 to 4 times the length of the second side line PH. In one example, the length of the first side line MN of the quadrilateral MNHP is equal to 1.2 to 2 times the length of the second side line pH, for example, the length of the first side line MN of the quadrilateral MNHP is 1.2 times, 1.5 times, 2 times, 2.5 times, 3 times or 4 times the length of the second side line PH. For example, the length of the third side line MP may be equal to the length of the fourth side line NH, and in this case, the quadrilateral MNHP is an isosceles trapezoid.

For example, in some embodiments, the length of the first side line MN of the quadrilateral MNHP is less than the length of the second side line PH, that is, the quadrilateral MNHP is a regular trapezoid.

For example, in some embodiments, the length of the first side line MN of the quadrilateral MNHP is equal to the length of the second side line PH, that is, the quadrilateral MNHP is rectangular.

For example, as shown in FIG. 3 and FIG. 4, a maximum thickness d1 of the auxiliary part 106 in the direction perpendicular to the main surface of the substrate 101 is greater than or equal to half of the thickness d2 of a part of the spacer 105 that is higher than the first surface 107a and smaller than the thickness d2 of the part of the spacer 105 that is higher than the first surface 107a. For example, in one example, the maximum thickness d1 of the auxiliary part 106 in the direction perpendicular to the main surface of the substrate 101 is greater than or equal to 0.7 times of the thickness d2 of the part of the spacer 105 that is higher than the first surface 107a and smaller than the thickness d2 of the part of the spacer 105 that is higher than the first surface 107a. For example, in another example, the maximum thickness d1 of the auxiliary part 106 in the direction perpendicular to the main surface of the substrate 101 is greater than or equal to 0.8 times of the thickness d2 of the part of the spacer 105 that is higher than the first surface 107a and less than or equal to 0.9 times of the thickness d2 of the part of the spacer 105 that is higher than the first surface 107a. Because the spacer 105 exposed at the top edge of the opening is hydrophobic and the auxiliary part 106 is lyophilic; the spacer 105 exposed at the top edge of the opening is lyophobic so that when ink is used to form a color control unit, the ink can enter the target opening as much as possible, and the ink is not left on the first side line MN of the spacer 105 as much as possible. The auxiliary part 106 is lyophilic, which can make the applied ink spread more easily in the opening, thus making the printed ink more evenly dispersed. If d1 is equal to or more than half of d2, the thickness d1 of the auxiliary part 106 can be made high enough to prevent the ink at the upper part of the opening from penetrating into the adjacent opening.

For example, in one embodiment, the auxiliary part 106 is an opaque structure, and the auxiliary part can absorb light to at least reduce light crosstalk between adjacent openings; alternatively, the auxiliary part 106 can have a function of reflecting light. On the one hand, the auxiliary part 106 can reflect the light that has crossed into the openings, and reduce the light crosstalk between adjacent openings. On the other hand, the auxiliary part 106 can reflect the light that is emitted by the color control unit and irradiated on the auxiliary part 106, so as to improve the color filtering effect of the color filter.

For example, the material of the auxiliary part 106 includes at least one selected from a group consisting of a black resin material and a metal material. For example, the black resin material includes a light-absorbing resin material including at least one selected from a group consisting of acrylic resin, epoxy resin, polyimide and polyethylene mixed with light-absorbing functional materials, for example, the light-absorbing functional materials may be aniline black, perylene black, titanium black, carbon black, or metal oxide with light-absorbing function. For example, the metal material includes one of gold, silver, aluminum and copper which can reflect light, or may also be molybdenum which can absorb light, which is not limited by the embodiments of the present disclosure.

For example, FIG. 8 is a schematic cross-sectional view of a color filter structure provided by still another embodiment of the present disclosure. The auxiliary part 106 includes a transparent first basic substance 108 and first scatter particles 109, and the first scatter particles 109 are distributed in the first basic substance 108.

For example, the first basic substance 108 includes a transparent resin, which is an ultraviolet curable resin, and the material of the first scatter particles 109 includes a transparent metal oxide, which may include at least one selected from a group consisting of titanium oxide or silicon oxide, for example.

For example, as shown in FIG. 8, the color control unit 102 includes a first color control unit 1021, the opening 104 includes a first opening 1041, the first color control unit 1021 is defined in the first opening 1041 divided by the pixel definition layer 103, and the first color control unit 1021 includes color conversion particles 110 for converting light with a first wavelength into light with a second wavelength. For example, the first wavelength is smaller than the second wavelength, and the light with the first wavelength has higher energy than the light with the second wavelength.

For example, the color conversion particles 110 include quantum dots, the quantum dots include a red quantum dot R or a green quantum dot G, correspondingly, the first color control units 1021 include a red control unit and a green control unit.

For example, the quantum dots may include one or more selected from a group consisting of CdTe, CdS, CdSe, ZnSe, ZnS, ZnTe, ZnO, HgTe, HgS, PbSe, InP, PbS, PbTe, SnSe, SnS, SnTe, InP, InAsP, InSb, InN, GaAs, GaP, GaN, $CsPbCl_3$, $CsPbBr_3$, $CsPbI_3$, GaInP, CuInSe, CuInS, AgInS, AgInSe, $Ag_2S$, $Ag_2Se$, CdS/ZnS, CdSe/ZnS, ZnSe, InP/ZnS, PbS/ZnS, $CsPbCl_3$/ZnS, $CsPbBr_3$/ZnS or $CsPbI_3$/ZnS.

For example, the quantum dots may include Mu doped with III-V groups colloidal quantum dots, Cu doped with III-V groups colloidal quantum dots and perovskite quantum dots.

For example, the color conversion particles 110 may be other substances with a function of wavelength conversion, for example, the color conversion particles 110 include organic molecules with a function of wavelength conversion.

The above-mentioned red control unit in the present disclosure means that light emitted from the red color control unit is mainly red light; the above-mentioned green control unit in the present disclosure means that light emitted from the green color control unit is mainly green light; the above-mentioned blue control unit in the present disclosure means that the light emitted from the blue color control unit is mainly blue light.

For example, in FIG. 8, the first scatter particles 109 are dispersed in the auxiliary part 106 in the first opening 1041, and the dispersed color conversion particles 110 are included in the first color control unit 1021. For example, the color conversion particles 110 are quantum dots. In the case where the second scatter particles 112 are dispersed in the first color control unit 1021, and when the light with the first wavelength emitted by the backlight enters the first color control unit 1021, and the light with the first wavelength is converted into the light with the second wavelength in the first color control unit 1021, the light with the second wavelength is scattered in the auxiliary part 106, the light is dispersed, and at least a part of the light re-enters the first color control unit 1021, so that the light emitted from the first color control unit is enhanced. For example, in the case where the second wavelength light is red light, the first color control unit 1021 is a red control unit; in the case where the second wavelength light is green light, the first color control unit 1021 is a green control unit.

For example, the second scatter particles 112 may also be dispersed in the first color control unit 1021.

For example, the sum of the mass percentages of the second scatter particles 112 and the color conversion particles 110 in the first color control unit 1021 is larger than the mass percentage of the first scatter particles 109 in the auxiliary part 106 in the first opening 1041.

For example, the mass percentage only of the second scatter particles 112 in the first color control unit 1021 is larger than the mass percentage of the first scatter particles 109 in the auxiliary part 106 in the first opening 1041.

For example, as shown in FIG 8, the color control unit 102 further includes a second color control unit 1022, the opening 104 further includes a second opening 1042, the second color control unit 1022 is defined in the second opening 1042 divided by the pixel definition layer 103, and the second color control unit 1022 is configured to transmit the light with the first wavelength entering the second color control unit 1022 at the first wavelength, and the second color control unit 1022 includes a light-transmissive second basic substance 111. For example, the light with the first wavelength light is blue light, and the second color control unit 1022 is a blue color control unit.

For example, in FIG. 8, the second color control unit 1022 includes the second scatter particles 112, and in the case where the second color control unit 1022 includes the second scatter particles 112, the second scatter particles 112 are distributed in the second basic substance 111.

For example, the second basic substance 111 includes a transparent resin, and the material of the second scatter particles 112 includes a transparent metal oxide which may include one or both of titanium oxide and silicon oxide.

For example, the first basic substance 108 is the same as the second basic substance 111, and both the first basic substance 108 and the second basic substance 111 may be transparent resins. For example, the transparent resin is an ultraviolet curable resin.

For example, the material of the auxiliary part 106 adjacent to the second color control unit 1022 may include the first scatter particles 109 dispersed in the first basic substance 108. For example, the material of the first scatter particles 109 may be the same the material of the second scatter particles 112.

For example, the mass percentage of the second scatter particles 112 in the second color control unit 1022 is smaller than the mass percentage of the first scatter particles 109 in the auxiliary part 106 adjacent to the second color control unit 1022. In the case where the concentration of the first scatter particles 109 in the auxiliary part 106 adjacent to the second color control unit 1022 is higher, the light entering the second color control unit 1022 can be further dispersed, the uniformity of the light emitted from the second color control unit 1022 can be increased, and the display effect can be improved.

It should be noted that, for clarity, FIG. 8 illustrates the case where the auxiliary parts 106 in the first opening 1041 and the second opening are arranged on one side wall of the spacer 105 that faces the color control unit, but the positions where the auxiliary parts are arranged are not limited to this case. For example, the auxiliary parts 106 may be provided on a plurality of side walls of the spacer 105 that face the color control unit. For example, the auxiliary parts 106 may be provided at each side wall of the spacer 105 facing the color control unit.

In some embodiments, the preparation of the auxiliary part 106 in the first opening and the auxiliary part 106 in the second opening can be achieved by a single process. For example, after the pixel definition layer is formed, a fluid (e.g., ink) containing an uncured first basic substance is placed in the second opening, and the fluid will enter the first opening through the bottom of the spacer 105 due to poor density, and after performing a curing process, the auxiliary part 106 in the first opening is formed. Particularly, because the auxiliary part is lyophilic to the fluid containing the uncured first basic substance, the auxiliary part 106 may be formed in each side wall of the spacer 105 facing the color control unit in the first opening. And the formed first cut-off contour line is a curved segment, and the curved segment is concave toward the inside of the auxiliary part. Particularly, the auxiliary part 106 in the second opening can be formed by controlling the volume of the fluid containing the first basic substance injected into the second opening. Particularly, the fluid may further include first scatter particles 109; it is not easy for the first scatter particles 109 to permeate through the bottom of the spacer 105, therefore, as the uncured first basic substance penetrates into the second opening, the auxiliary part 106 in the second opening contains the first scatter particles 109 with a higher mass percentage. And in this case, the auxiliary part 106 in the second opening contains the first scatter particles 109 with a low mass percentage, or the auxiliary part 106 in the second opening does not contain the first scatter particles 109. Particularly, in some embodiments, the preparation of the auxiliary part 106 in the first opening and the second color control unit can be realized by one process: in the case where the volume of the fluid containing the first basic substance injected into the second opening is large, the first basic substance fills the second opening to an ideal state, and the second color control unit and the auxiliary part 106 in the first opening can be formed by one process.

The above-mentioned embodiment of the preparation method is explained by taking, the case that the fluid containing the uncured first basic substance is injected into the second opening to make the auxiliary part 106, as an example. It can be understood that the fluid containing the uncured first basic substance may also be injected into the first opening, and the auxiliary part 106 can be made in the second opening through the infiltration of the bottom of the spacer 105.

For example, FIG. 9 is a schematic cross-sectional view of a color filter structure provided by still another embodiment of the present disclosure, and the auxiliary part 106 is a light-transmissive structure. As shown in FIG. 9, the auxiliary part 106 in the opening corresponding to the second color control unit 1022 does not contain the first scatter particles, and the auxiliary part 106 in the opening corresponding to the first color control unit 1021 contains the first scatter particles 109.

For example, FIG. 10 is a schematic cross-sectional structure diagram of a color filter structure provided by still another embodiment of the present disclosure. As shown in FIG. 10, the second color control unit 1022 includes dispersed second scatter particles 112 and blue quantum dots 114, the second scatter particles 112 and blue quantum dots 114 may be dispersed in the third basic substance 113. The blue quantum dots 114 can convert the light with the first wavelength into light with the third wavelength, the third wavelength is larger than the first wavelength, that is, the light with the shorter wavelength is used to excite the light with the longer wavelength to emit. For example, in one example, the light with the first wavelength is purple light or ultraviolet light, and the light with the third wavelength is blue light.

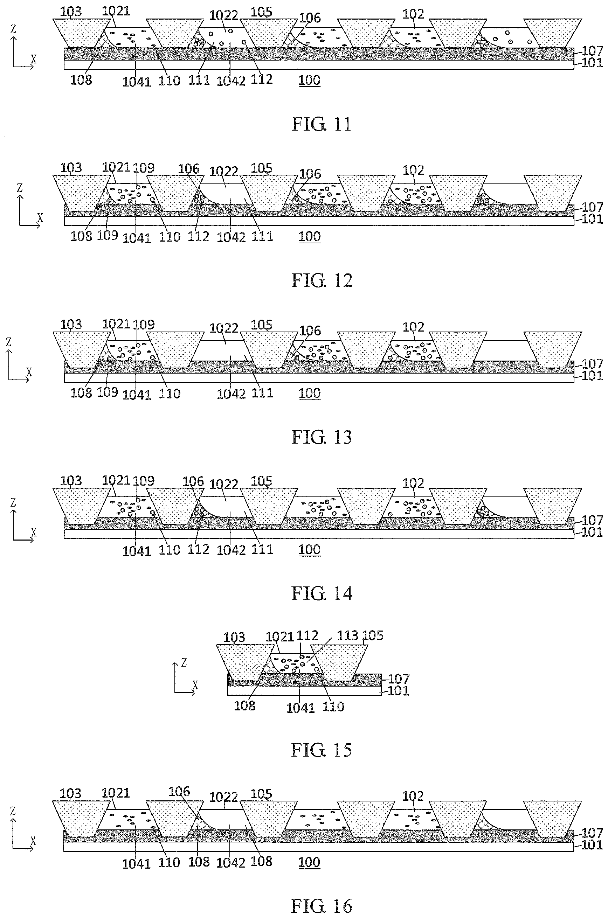

For example, FIG. 11 is a schematic cross-sectional structure diagram of a color filter structure provided by still another embodiment of the present disclosure, and the auxiliary part 106 is a light-transmissive structure. As shown in FIG. 11, the auxiliary part 106 in the opening corresponding to the first color control unit 1021 does not contain the first scatter particles 109, but only includes the first basic substance 108. The auxiliary part 106 in the corresponding opening of the second color control unit 1022 includes the first scatter particles 109.

For example, FIG. 12 is a schematic cross-sectional structure diagram of a color filter structure provided by still another embodiment of the present disclosure. In FIG. 12, the material of the auxiliary part 106 adjacent to the second color control unit 1022 includes the first scatter particles 109 dispersed in the first basic substance 108, and the second color control unit 1022 does not include the scatter particles. In the structure shown in FIG. 12, the auxiliary part 106 and the second color control unit 1022 may be formed in two different steps, and the materials of the basic substrates included in the auxiliary part 106 and the second color control unit 1022 may be the same. That is, the auxiliary part 109 with the second basic substance 111 and the second scatter particles 112 is formed in the second opening first, and then the second color control unit 1022 with only the second basic substance 111 is formed in the second opening.

For example, as shown in FIG. 12, the second opening 1042 is adjacent to at least one first opening 1041, that is, a corresponding first color control unit 1021 is adjacent to at least one second color control unit 1022.

It should be noted that the first color control unit or the second color control unit is adjacent to the auxiliary part, which means that in one same opening, the first color control unit or the second color control unit is in direct contact with the auxiliary part and is adjacent to the auxiliary part. Two openings are adjacent to each other, which means that there is no other opening in the two openings.

For example, FIG. 13 is a schematic cross-sectional structure diagram of a color filter structure provided by still another embodiment of the present disclosure. As shown in FIG. 13, the auxiliary part 106 is only provided in the first opening 1041, and no auxiliary part is provided in the second opening 1042. Optionally, the second color control unit includes the second scatter particles 112, and the auxiliary part 106 in the first opening 1041 includes the first scatter particles 109, and the first scatter particles 109 and the second scatter particles 112 are the same scatter particles. Alternatively, the second color control unit includes the second scatter particles 112, and the auxiliary part 106 in the first opening 1041 does not include the scatter particles.

For example, FIG. 14 is a schematic cross-sectional structure diagram of a color filter structure provided by still another embodiment of the present disclosure. As shown in FIG. 14, the auxiliary part 106 is only provided in the second opening 1042, and no auxiliary part is provided in the first opening 1041. In a specific embodiment, when the auxiliary part 106 in the second opening 1042 is prepared by using the fluid containing the uncured first basic substance, the fluid permeating into the bottom of the spacer 105 may not enter the second opening 1041 through the spacer 105, so the auxiliary part 106 is only formed in the second opening 1042 after the curing process. It can be understood that with a similar method, the auxiliary part 106 can be provided only in the first opening 1041, and the second opening 1042 is not provided with the auxiliary part.

For example, in the case where the auxiliary part 106 is disposed in the first opening 1041, the refractive index of the auxiliary part 106 is smaller than that of the first color control unit 1021.

For example, FIG. 15 is a schematic cross-sectional structure diagram of a color filter structure provided by still another embodiment of the present disclosure, and the auxiliary part 106 is a light-transmissive structure. As shown in FIG. 15, the light-transmissive structure included in the auxiliary part 106 only includes the first basic substance 108. Specifically, the refractive index of the auxiliary part 106 is smaller than that of the first color control unit 1021. When light enters the auxiliary part 106 (light-sparse medium) from the first color control unit 1021 (light-dense medium), the light entering the auxiliary part 106 can be dispersed due to the light refraction effect. The dispersion of the light entering the auxiliary part 106 is beneficial for the light to enter the first color control unit again and be utilized. For example, the light can be returned to the first color control unit 1021 through the reflection layer between the substrate and the first color control unit (for example, the color filter is used in a QD-OLED display device, the metal cathode of OLED can be used as the reflection layer), so that the light utilization rate is improved, the light conversion efficiency of the first color control unit 1021 is further improved, and the display effect is improved.

For example, the color control unit further includes a second color control unit 1022, and the opening further includes a second opening 1042. In the case where the auxiliary part 106 is only provided in the first opening 1041, the refractive index of the auxiliary part 106 is smaller than that of the first color control unit 1021.

For example, the color control unit further includes a second color control unit 1022, and the openings further includes a second opening 1042. In the case where the auxiliary part 106 is only provided in the second opening 1042, the refractive index of the auxiliary part 106 is larger than that of the second color control unit 1022. For example, FIG. 16 is a schematic cross-sectional structure diagram of a color filter structure provided by still another embodiment of the present disclosure, and the auxiliary part 106 is a light-transmissive structure and is only provided in the second opening 1042. The refractive index of the auxiliary part 106 is larger than that of the second color control unit 1022. When light enters the auxiliary part 106 (light-dense medium) from the second color control unit 1022 (light-sparse medium), the light entering the auxiliary part 106 can be gathered together due to the light refraction effect.

In a specific embodiment, the spacer 105 has a reflective property, for example, the spacer 105 may be a resin with reflective effect, and at least a part of the gathered light is reflected by the spacer layer 105 in a specific direction, for example, it is emitted from the light incident side of the second color control unit 1022, but not from the light output side of the second color control unit 1022, which is beneficial to reduce the intensity of the light emitted from the second opening. In another specific embodiment, the spacer 105 has a light absorption property, for example, the spacer 105 may be a resin with a light absorption effect. At least a part of the gathered light is absorbed by the spacer 105, and will not be emitted from the light-emitting side of the second color control unit 1022, which is beneficial to reduce the intensity of the light emitted from the second opening. In still another specific embodiment, at least a part of the gathered light can be emitted from the light incident side of the second color control unit 1022, and propagation or reentry propagation in the light-transmissive medium (for example, in the isolation layer between the light-emitting unit of the QD-OLED display panel and the color filter structure) along the direction horizontal to the main surface of the substrate 101, which is beneficial to reduce the intensity of the light emitted from the second opening. In some embodiments, the brightness of the light emitted from the second opening is higher than that of the light emitted from the first opening (for example, the light emitted from the second opening is still the light with the first wavelength without wavelength conversion), and reducing the intensity of the light emitted from the second opening is beneficial to balance the brightness of the light emitted from the color filter, thereby improving the color gamut of the display panel.

For example, in the case where the auxiliary parts are arranged in both the first opening and the second opening, the refractive index of the auxiliary part located in the first opening is less than or equal to that of the first color control unit, and the refractive index of the auxiliary part located in the second opening is greater than that of the second color control unit; or, the refractive index of the auxiliary part located in the first opening is smaller than that of the first color control unit, and the refractive index of the auxiliary part located in the second opening is equal to that of the second color control unit.

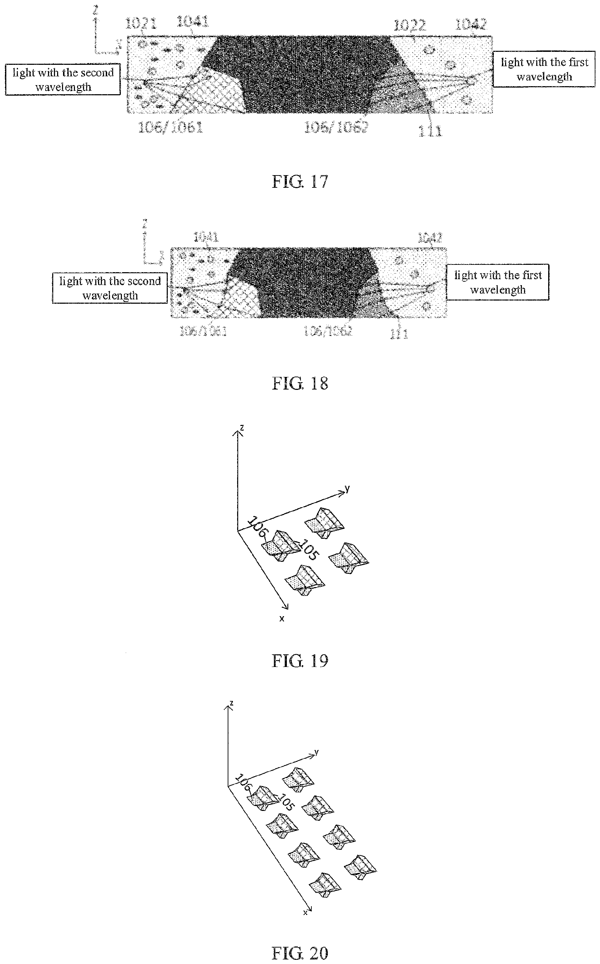

For example, FIG. 17 is a schematic cross-sectional structure diagram of a color filter structure provided by still another embodiment of the present disclosure. As shown in FIG. 17, the auxiliary part 106 in the first opening 1041 is the first auxiliary part 1061, and the auxiliary part 106 in the second opening 1042 is the second auxiliary part 106. The refractive index of the first auxiliary part 1061 may be less than or equal to that of the first color control unit 1021, and the refractive index of the second auxiliary part 1062 is greater than that of the second color control unit 1022. Alternatively, the refractive index of the first auxiliary part 1061 may be smaller than that of the first color control unit 1021, and the refractive index of the second auxiliary part 1062 may be equal to that of the second color control unit 1022. This embodiment includes at least one of the following effects: 1. the light with the second wavelength is dispersed in the first opening 1041; 2. the light with the first wavelength is gathered in the second opening 1042. For example, the first color control unit 1021 may be a red control unit or a green control unit, and the second color control unit 1022 may be a blue control unit. The arrangement in this embodiment is beneficial to balancing the light intensity difference between red light or green light and blue light, thereby improving the color gamut of the display panel.

For example, FIG. 18 is a schematic diagram of a light ray with a first wavelength gathered in a second opening and a light ray with a second wavelength dispersed in a first opening provided by an embodiment of the present disclosure. The structure shown in FIG. 18 differs from that shown in FIG. 17 only in that the fifth surface of the auxiliary part 106 in FIG. 18 has a corresponding first cut-off contour line in the direction perpendicular to the main surface of the substrate 101, and the first cut-off contour line is a curved segment, the curved segment concave towards the inside of the auxiliary part 106.

It should be noted that in the above embodiment, the refractive index of the first color control unit 1021 may be the average refractive index of the plurality of the first color control units 1021. The refractive index of the second color control unit 1022 may be the average refractive index of the plurality of the second color control units 1022. The refractive index of the first auxiliary part 1061 may be the average refractive index of the plurality of the first auxiliary parts 1061, and the refractive index of the second auxiliary part 1062 may be the average refractive index of the plurality of the second auxiliary parts 1062. The average refractive index may be expressed as:

$$\overline{n} = \sum_{i=1}^{i=j} Xi \bullet ni \, ,$$

in which $j$ represents an integer greater than or equal to 1, indicating that there are j components in the color control unit. $Xi$ represents the mass percentage of the $i$-th component, and $ni$ represents the refractive index of the i-th component. For example, in the case where the color control unit is composed of a basic substance, quantum dots dispersed in the basic substance and second scatter particles, $j=3$.

In some embodiments, the first color control unit 1021 includes a fourth basic substance 117, and the color conversion particles 110 may be dispersed in the matrix. Preferably, the second scatter particles 112 are dispersed in the fourth basic substance 117. The refractive index of the fourth basic substance 117 is larger than that of the first auxiliary part 1061. In some embodiments, the first auxiliary part 1061 includes a fifth basic substance 118 and scatter particles dispersed in the fifth basic substance 118, and the refractive index of the fourth basic substance 117 is greater than that of the fifth basic substance 118.

In some embodiments, the second color control unit 1022 includes a third basic substance 113, and preferably, the second scatter particles 112 are dispersed in the third basic substance 113. The refractive index of the third basic substance 113 is smaller than that of the first auxiliary part 1061. In some embodiments, the second auxiliary part 1062 includes a sixth basic substance 119 and scatter particles dispersed in the sixth basic substance 119, and the refractive index of the third basic substance 113 is greater than that of the sixth basic substance 119.

For example, in the embodiment of the present disclosure, with reference to FIG. 2 to FIG. 4 and FIG. 8 to FIG. 16, the spacer 105 has lyophilicity and the auxiliary part 106 has lyophilicity. For example, the spacer 105 is lyophobic, so that it has a large contact angle with water, which can make it difficult for the ink to spread when the ink is applied, thus making it easier for the applied ink to completely enter the corresponding opening 104 instead of flowing into the adjacent inappropriate opening 104. The auxiliary part 106 has lyophilicity, so that the auxiliary part 106 has a small contact angle with water, that is, good lyophilicity, which makes it easy for the applied ink to spread in the corresponding opening 104, thus making it easier to form the first color control unit and the second color control unit which are uniform and have a certain thickness.

In a specific embodiment, the contact angle of propylene glycol methyl ether acetate (PGMEA) in the spacer is greater than or equal to 40 degrees, and the contact angle of water in the auxiliary part is less than or equal to 20 degrees.

In another specific embodiment, the contact angle with water of the spacer is greater than or equal to 90 degrees, and the contact angle with water of the auxiliary part is less than or equal to 50 degrees. For example, in the case where the contact angle with water of the spacer 105 is less than 90 degrees, it is easy for the applied ink to enter the inappropriate opening 104, thus easily causing the phenomenon of cross-color. In the case where the contact angle with the water of the auxiliary part 106 is greater than 50 degrees, it is difficult for the applied ink to spread in the corresponding opening 104, thus causing the thickness of the formed first color unit 1021 or the second color unit 1022 to be uneven, eventually leading to uneven light emission and uneven light mixing. The contact angle with water of the spacer is greater than or equal to 90 degrees, that is, the spacer cannot show hydrophilicity to the ink, and it is easy for the ink to enter the target opening.

For example, the material of the spacer 105 includes a heat curable resin including at least one selected from a group consisting of melamine formaldehyde resin, furan resin, polybutadiene resin and silicone resin.

For example, FIG. 19 is a schematic planar view of the arrangement of spacers and auxiliary parts in a color filter structure provided by an embodiment of the present disclosure. As shown in FIG. 19, a plurality of spacers 105 are distributed in an array; along the row direction (the direction parallel to the X axis), one side wall of each of the spacers 105 is provided with an auxiliary part 106; along the column direction (the direction parallel to the Y axis), one side wall of each of the spacers 105 is provided with the auxiliary part 106, and the compactability of the auxiliary part 106 is greater than or equal to the compactability of the bottom of the spacer 105, so that the phenomenon that printing ink in one pixel region permeates into the adjacent pixel region can be reduced or eliminated, and then the phenomenon of color cross can be reduced, ensuring a high color gamut. In addition, along the row direction or the column direction, the auxiliary part 106 is only provided on one side wall of each of the spacers 105 can ensure that the first color control unit and the second color control unit formed later have sufficient installation space.

For example, FIG. 20 is a schematic planar view of the arrangement of spacers and auxiliary parts in another color filter structure provided by an embodiment of the present disclosure. As shown in FIG. 20, a plurality of spacers 105 are distributed in an array, and along the row direction (the direction parallel to the X axis), auxiliary parts 106 are respectively arranged on two opposite side walls of the same spacer 105, and along the column direction (the direction parallel to the Y axis), the auxiliary parts 106 are respectively provided on two opposite side walls of a same spacer 105. In FIG. 20, because a part of the side walls is shaded, it is only shown that the auxiliary part 106 is on one side of one side wall of each of the spacers 105 along the column direction, but in the actual structure, the auxiliary parts 106 are provided on two opposite side walls of each of the spacers 105.

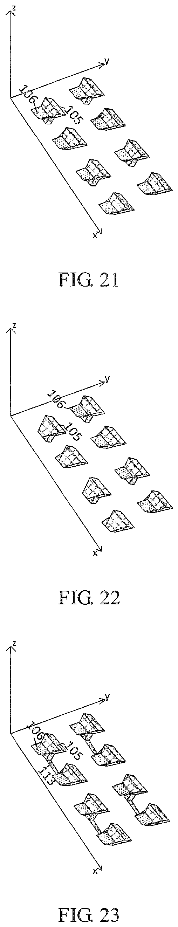

For example, FIG. 21 is a schematic planar view of the arrangement of spacers and auxiliary parts in still another color filter structure provided by an embodiment of the present disclosure. As shown in FIG. 21, along the row direction (the direction parallel to the X axis), the auxiliary parts 106 are respectively arranged on the side walls closest to each other of two adjacent spacers 105, and along the column direction (the direction parallel to the Y axis), the auxiliary parts 106 are respectively arranged on two opposite side walls of the same spacer 105, which is different from the case shown in FIG. 20 that each of the openings is provided with the auxiliary part 106. In FIG. 21, along the column direction, because a part of the side wall is shaded, it is only shown that the auxiliary part 106 is on one side of one side wall of each of the spacers 105 along the column direction, but in the actual structure, it is the way shown in the example.

Alternatively, FIG. 22 is a schematic planar view of the arrangement of spacers and auxiliary parts in still another color filter structure provided by an embodiment of the present disclosure. As shown in FIG. 22, along the row direction (the direction parallel to the X axis), auxiliary parts 106 are respectively arranged on the side walls closest to each other of two adjacent spacers 105, and along the column direction (the direction parallel to the Y axis), auxiliary parts 106 are respectively arranged on the side walls closest to each other of two adjacent spacers 105. And is different from that in FIG. 20, each opening is provided with an auxiliary part 106, and in FIG. 22, the auxiliary part 106 is provided every other opening along the column direction. In FIG. 22, along the column direction, the auxiliary part 106 can only be shown on one side of one side wall of each spacer 105 due to the shielding of the side wall. In the actual structure, it is the arrangement described in this example.

For example, FIG. 23 is a schematic planar view of the arrangement of spacers and auxiliary parts in still another color filter structure provided by an embodiment of the present disclosure. For example, along the row direction (the direction parallel to the X axis), in the case where the auxiliary parts 106 are respectively arranged on the side walls closest to each other of two adjacent spacers 105, the auxiliary parts 106 respectively arranged on the side walls closest to each other of two adjacent spacers 105 are connected to each other, and the connection part 113a is the part that connects the auxiliary parts 106 on the side walls closest to each other of the two adjacent spacers 105. In this way, the auxiliary part 106 is in contact with the first surface 107a shown in FIG. 3, the first color control unit or the second color control unit respectively through the connection part 113a. And the material of the connection part 113a is the same as that of the auxiliary part 106. In FIG. 23, in order to show the connection part, the first color control unit or the second color control unit on the connection part 113a is omitted. Correspondingly, connection parts may be provided along the column direction, and the connection parts in the column direction are omitted for the sake of clarity of the FIG. 23.

For example, the connecting portion 113a can be formed by diffusion of the applied material of the auxiliary part 106, that is, the connecting portion 113a can be formed without additional process steps.

For example, in FIG. 20, in the case where the auxiliary parts 106 are respectively arranged on the side walls closest to each other of two adjacent spacers 105, the auxiliary parts 106 respectively arranged on the side walls closest to each other of two adjacent spacers 105 are disconnected from each other.

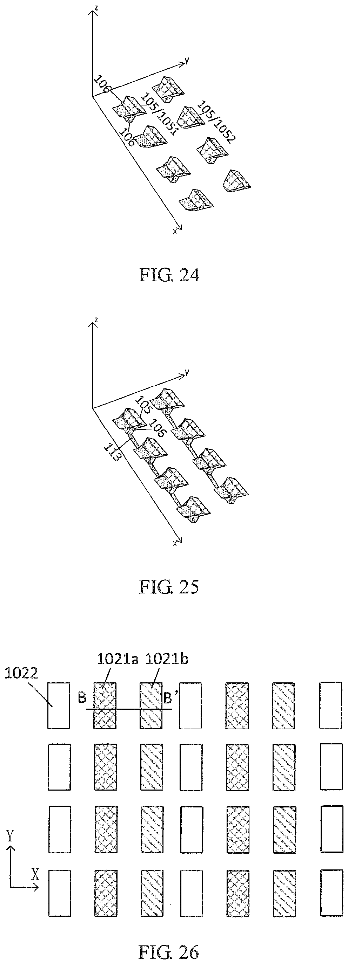

For example, FIG. 24 is a schematic planar view of the arrangement of spacers and auxiliary parts in still another color filter structure provided by an embodiment of the present disclosure. As shown in FIG. 24, the plurality of spacers 105 are distributed in an array, and the spacers 105 include the first spacers 1051 and the second spacers 1052 which are adjacent and alternately arranged. Along the row direction (the direction parallel to the X axis), the auxiliary parts 106 are arranged on two opposite side walls of the first spacers 1051. Moreover, the second spacer 1052 has no auxiliary parts 106 on the two opposite side walls thereof, and the first spacer 1051 has auxiliary parts 106 on two opposite side walls thereof, and along the column direction (the direction parallel to the Y axis), the first spacer 1051 is provided with the auxiliary parts 106 on two opposite side walls (due to shading in the figure, along the column direction, the other side wall of the first spacer is not provided with the auxiliary part), and two adjacent side walls of the second spacer 1052 are not provided with the auxiliary part 106.

For example, FIG. 25 is a schematic planar view of the arrangement of spacers and auxiliary parts in still another color filter structure provided by an embodiment of the present disclosure. As shown in FIG. 25, a plurality of spacers 105 are distributed in an array, and along the row direction (the direction parallel to the X axis), the auxiliary parts 106 are arranged on two opposite side walls of each of the spacers 105, and the auxiliary parts 106 on the side walls closest to each other of two adjacent spacers 105 are connected to each other. Along the column direction (the direction parallel to the Y axis), the auxiliary parts 106 are provided on two opposite side walls of each of the spacers 105, and the auxiliary parts 106 on the side walls closest to each other of two adjacent spacers 105 are connected to each other by the connection part which is omitted in the column direction for the sake of clarity of the FIG. 25. In this way, the auxiliary part 106 is in contact with the first surface 107a shown in FIG. 3, the first color control unit or the second color control unit respectively through the connection part 113a. And the material of the connection part 113a is the same as that of the auxiliary part 106. In FIG. 19, the first color control unit or the second color control unit on the connection part 113a is omitted to show the connection part 113a in the row direction.

For example, along the row direction, the auxiliary parts 106 on the side walls closest to each other of two adjacent spacers 105 may be disconnected from each other, and along the column direction, the auxiliary parts on the side walls closest to each other of adjacent spacers may be disconnected from each other, which can be referred to the embodiment shown in FIG. 20, for an example.

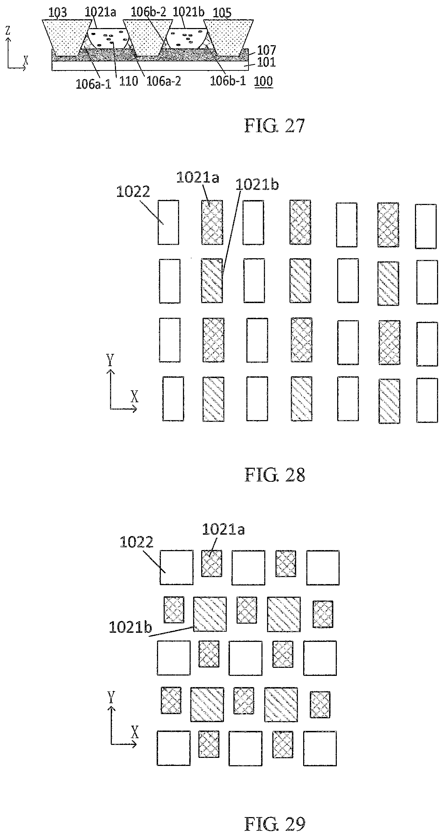

For example, FIG. 26 is a planar view of distribution of the pixel control units of a color filter provided by an embodiment of the present disclosure. As shown in FIG. 26, the pixel control units are distributed in an array. Each column includes the same pixel control unit, and each row includes first color control units 1021a, 1021b and a second color control unit 1022 arranged periodically, the first color control unit 1021a and the first color control unit 1021b are different first color control units. For example, the first color control unit 1021a is a red control unit, the first color control unit 1021b is a green control unit, and the second color control unit 1022 is a blue control unit. For example, the first color control unit 1021a includes red quantum dots, the first color control unit 1021b includes green quantum dots, and the second color control unit 1022 includes a transparent resin. The auxiliary part 106 is provided at least in the first openings corresponding to the first color control unit 1021a and the first color control unit 1021b. In a specific embodiment, with reference to FIG. 26, a cross-section is obtained by taking along the line B-B' (i.e., X direction), and for example, FIG. 27 is a schematic cross-sectional view of the color filter structure in FIG. 26 by taking along line B-B'. As shown in FIG. 27, the auxiliary parts 106 are respectively arranged in the openings corresponding to the first color control units 1021a and 1021b. Specifically, in the opening corresponding to the first color control unit 1021a, an auxiliary part 106a-1 is arranged on the side wall of the spacer between the first color control unit 1021a and the second color control unit 1022, and an auxiliary part 106a-2 is arranged on the side wall of the spacer between the first color control unit 1021a and the first color control unit 1021b. In the opening corresponding to the first color control unit 1021b, an auxiliary part 106b-1 is provided on the side wall of the spacer between the first color control unit 1021b and the second color control unit 1022, and an auxiliary part 106b-2 is provided on the side wall of the spacer between the first color control unit 1021b and the first color control unit 1021a. In some embodiments, for example, as shown in FIG. 27, a maximum thickness of the auxiliary part 106a-1 in the direction perpendicular to the substrate is greater than that of the auxiliary part 106a-2 in the direction perpendicular to the substrate; a maximum thickness of the auxiliary part 106b-1 in the direction perpendicular to the substrate is larger than that of the auxiliary part 106b-2 in the direction perpendicular to the substrate. In some embodiments, the thickness difference of the auxiliary part can be realized by one process. For example, after the pixel definition layer is formed, a fluid (e.g., ink) containing the uncured first basic substance is placed in the second opening, and the fluid will enter the first opening through the bottom of the spacer 105 with poor density, and after a curing process, the auxiliary part 106 in the first opening is formed. However, the corresponding positions of the auxiliary parts (e.g., the auxiliary parts 106a-1, 106b-1) close to the second opening are more easily supplied by the permeated fluid than the positions of the auxiliary parts (e.g., the auxiliary parts 106a-2, 106b-2) far away from the second opening. Therefore, the auxiliary part close to the second opening has a greater thickness than the auxiliary part far away from the second opening. It can be understood that the pixel arrangement of FIG. 26 in the present disclosure is only for convenience in explaining the cause of the maximum thickness difference in the direction perpendicular to the substrate, and is not intended to limit the arrangement form of the pixels. For other pixel arrangement forms, the relative relation of the maximum thickness of the auxiliary part perpendicular to the substrate can be obtained from the supply of the permeated fluid at the corresponding positions of the auxiliary parts.

For example, the auxiliary parts 106 are continuously arranged around the inner wall of the first opening 1041 where the first color control unit 1021 is located, and the auxiliary parts 106 are continuously arranged around the inner wall of the second opening 1042 where the second color control unit 1022 is located. Continuous arrangement means that in the first opening 1041 or the second opening 1042, the auxiliary part 106 smoothly transitions from one spacer 105 to another spacer 105 adjacent to the one spacer 105.

For example, FIG. 28 is a planar view of distribution of the pixel control units of a color filter provided by another embodiment of the present disclosure. As shown in FIG. 28, the pixel control units are distributed in an array. Each odd-numbered column includes the same second color control units 1022, and each even-numbered column includes the first color control units 1021a and 1021b arranged alternately, the first color control unit 1021a and the first color control unit 1021b are different first color control units. For example, the first color control unit 1021a is a red control unit, the first color control unit 1021b is a green control unit, and the second color control unit 1022 is a blue control unit. For example, the first color control unit 1021a includes red quantum dots, the first color control unit 1021b includes green quantum dots, and the second color control unit 1022 includes transparent resin. The auxiliary part 106 is provided at least in the first openings corresponding to the first color control unit 1021a and the first color control unit 1021b.

For example, FIG. 29 is a planar view of distribution of the pixel control units of a color filter provided by still another embodiment of the present disclosure. As shown in FIG. 29, the pixel control units are distributed in an array. Each odd-numbered column includes the second color control unit 1022 and the first color control units 1021a which are alternately arranged, and each even-numbered column includes the first color control unit 1021a and the first color control unit 1021b that are alternately arranged; meanwhile, each odd-numbered row includes the second color control unit 1022 and the first color control unit 1021a that are alternately arranged, and each even-numbered row includes the first color control unit 1021a and the first color control unit 1021b which are alternately arranged. The first color control unit 1021a and the first color control unit 1021b are different first color control units. For example, the first color control unit 1021a is a red control unit, the first color control unit 1021b is a green control unit, and the second color control unit 1022 is a blue control unit. For example, the first color control unit 1021a includes red quantum dots, the first color control unit 1021b includes green quantum dots, and the second color control unit 1022 includes a transparent resin. The auxiliary part 106 is provided at least in the first opening corresponding to the first color control unit 1021a. In some embodiments, the auxiliary part 106 may be disposed in the first opening corresponding to the first color control unit 1021b.

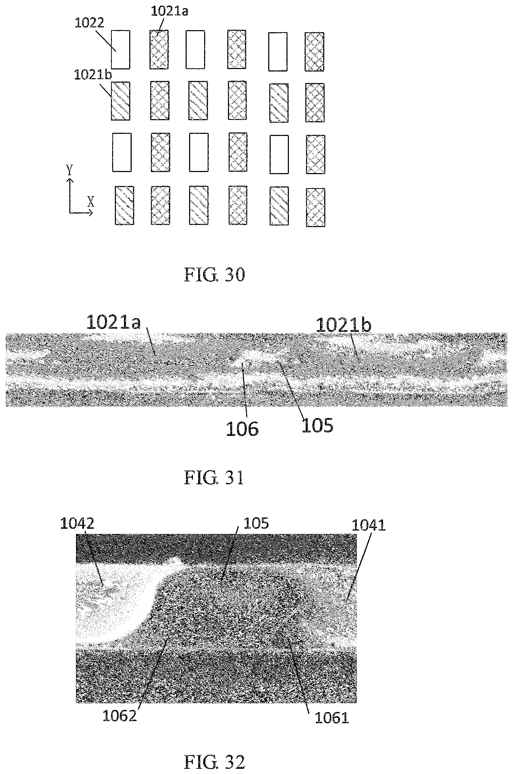

For example, FIG. 30 is a planar view of distribution of the pixel control units of a color filter provided by still another embodiment of the present disclosure. As shown in FIG. 30, the pixel control units are distributed in an array. Each odd-numbered column includes a second color control unit 1022 and a first color control unit 1021b that are arranged periodically, and each even-numbered column includes the same first color control units 1021a; meanwhile, each odd-numbered row includes the second color control unit 1022 and the first color control unit 1021a arranged periodically, and each even-numbered row includes the first color control unit 1021b and the first color control unit 1021a that are arranged periodically. The first color control unit 1021a and the first color control unit 1021b are different first color control units. For example, the first color control unit 1021a is a red control unit, the first color control unit 1021b is a green control unit, and the second color control unit 1022 is a blue control unit. For example, the first color control unit 1021a includes red quantum dots, the first color control unit 1021b includes green quantum dots, and the second color control unit 1022 includes transparent resin. The auxiliary parts 106 are provided at least in the first openings corresponding to the first color control units 1021b and the first openings corresponding to at least a part of the first color control units 1021a.

The auxiliary part 106 shown in FIG. 28 to FIG. 30 may be realized by a one manufacturing process. For example, after the pixel definition layer is formed, a fluid (e.g., ink) containing an uncured first basic substance is placed in the second opening, and then the fluid enters the first openings adjacent to the second openings both in the row direction and in the column direction through the bottom of the spacer 105 with poor density, and after a curing process, the auxiliary part 106 in the first opening is formed. In some embodiments, the fluid containing the uncured first basic substance may also enter the first openings which are not adjacent to the second openings in the row direction or in the column direction, therefore the fluid containing the uncured first basic substance can enter the first color control unit 1021b of the embodiment shown in FIG. 29 and form the auxiliary part 106 after being cured.

It is worth noting that in the above embodiment, the term "odd-numbered column", "even-numbered column", "odd-numbered row" and "even-numbered row" only illustrate the positional relationship between the pixels, but not limit the absolute position of the pixels in the color filter.

For example, FIG. 31 is a scanning electron microscope diagram including a spacer and an auxiliary part provided by an embodiment of the present disclosure, the spacer 105 and two auxiliary parts 106 respectively located on two side walls of the spacer 105 are shown. The spacer separates two first openings 1041, and two different first color control units 1021a and 1021b are respectively arranged in the two first openings. The first color control unit 1021a and the first color control unit 1021b respectively have different color conversion particles, and the color conversion particles are quantum dots.

For example, FIG. 32 is another scanning electron microscope diagram including a spacer and an auxiliary part provided by an embodiment of the present disclosure. In which the spacer 105 and two auxiliary parts 1061 and 1062 respectively located on two side walls of the spacer 105 are shown. The spacer separates the two first openings 1041 and the second openings 1042. The first opening 1041 includes a first color control unit 1021 with the color conversion particles, and the color conversion particles are quantum dots. The second opening 1042 may be filled with the second color control unit 1022.

The spacer includes the first auxiliary part 1061 on the side wall of the first opening and the second auxiliary part 1062 on the side wall of the second opening. It can be seen that the second auxiliary part 1062 includes the first scatter particles, and the first auxiliary part 1061 has no or almost no the first scatter particles. In FIG. 21, the preparation of the auxiliary part 106 in the first opening and the second opening can be realized by one process. That is, a fluid containing an uncured first basic substance is placed in the second opening, and the fluid further contains first scatter particles. The uncured first basic substance permeates into the first opening through the bottom of the spacer 105. Then, a curing process is performed to form the first auxiliary part 1061 and the second auxiliary part 1062.

At least one embodiment of the present disclosure further provides a display panel, and the display panel includes the color filter structure of any one of the above embodiments, a plurality of light-emitting units are arranged on a base substrate, and the color control units are arranged on a side of the plurality of light-emitting units away from the base substrate, and light emitted by the plurality of light-emitting units are emitted through the plurality of color control units.

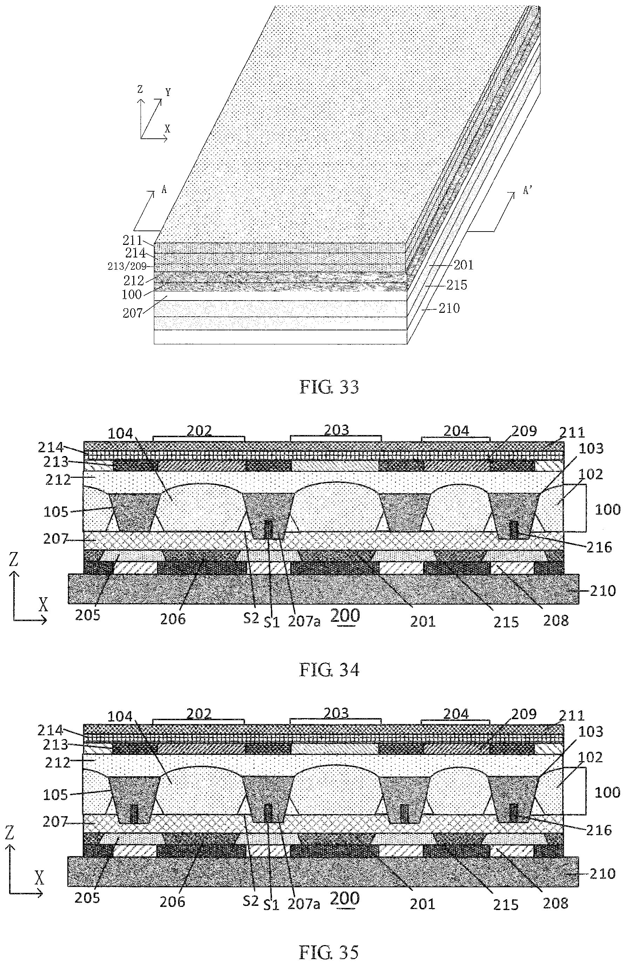

For example, as shown in FIG. 33, the display panel 200 may include a plurality of light-emitting units 201 disposed on the base substrate, and the color control units 102 included in the color filter structure 100 are disposed on a side of the plurality of light-emitting units away from the base substrate, and light emitted by the plurality of light-emitting units 201 is emitted through the plurality of color control units 102.

In a specific embodiment, the display panel 200 may include a base substrate 210, a reflection electrode 215 disposed on the base substrate 210, a plurality of light-emitting units 201, an isolation layer 207, a color filter structure 100, an encapsulation layer 212, a color film 209, a black matrix 213, a reflection polarizer 214, and a cover film 211. The color filter structure 100 includes the color control units 102.

For example, FIG. 34 is a schematic cross-sectional view of the display panel in FIG. 33 taken along the line A-A'. As shown in FIG. 34, the display panel 200 includes the color filter structure 100 in any one of the above embodiments, a plurality of light-emitting units 201 arranged on the base substrate 210, and the color control units 102 are arranged on the side of the light-emitting units 201 away from the base substrate 210, and light emitted by the light-emitting units 201 are emitted after passing through the color control units 100.

For example, the base substrate 210 may be a suitable substrate such as a glass substrate, a flexible substrate and so on.

It is worth noting that in the display panel provided by the embodiment of the present disclosure, the base substrate 210 on which the color filter structure in any of the above embodiments is placed and the substrate 101 may be the same substrate.

For example, the light-emitting elements corresponding to the plurality of light-emitting units 201 are organic electroluminescent diode (OLED) devices.

For example, the plurality of color control units 102 include a red control unit, a green control unit, and a blue control unit.

For example, as shown in FIG. 34, the display panel 200 includes sub-pixels arranged in an array, the sub-pixels arranged in the array include a first sub-pixel 202, a second sub-pixel 203 and a third sub-pixel 204, and each of the first sub-pixel 202, the second sub-pixel 203 and the third sub-pixel 204 includes a light-emitting unit 201 and a color filter structure 100. For example, other layer structures may be included between the light-emitting unit 201 and the color filter structure 100, and it is not limited to directly forming the color filter structure 100 on the light-emitting unit 201.

For example, as shown in FIG. 34, the display panel 200 further includes a light-emitting unit definition layer 205, the light-emitting unit definition layer 205 includes a plurality of pixel openings 206, the plurality of light-emitting units 201 are arranged in the plurality of pixel openings 206 in one-to-one correspondence, and the orthographic projection of each of the pixel openings 206 is within the orthographic projection of the corresponding opening 104. The light-emitting unit definition layer 205 separates the adjacent light-emitting units 201, so that the intensity of light with the first wavelength entering each opening 104 is the same, thus ensuring the uniformity of light emission.

For example, as shown in FIG. 34, the display panel 200 further includes an isolation layer 207, the plurality of light-emitting units 201 are separated from the color filter structure 100 by the isolation layer 207, and the color filter structure 100 is directly disposed on the isolation layer 207, the isolation layer 207 may be an interlayer insulation layer or an encapsulation layer and so on. The material of the isolation layer includes a transparent material, so that the light emitted by the light-emitting units 201 can be incident into the corresponding opening 104.

For example, as shown in FIG. 34, the side of the isolation layer 207 away from the base substrate 201 has an isolation layer opening area 207a, and at least a part of at least one spacer 105 is disposed in the isolation layer opening area 207a. The spacer 105 may be the substrate included in the color filter structure 100, that is, in some spacers 105, a part of the bottom of the spacer 105 is on the first surface S1 and the other part of the bottom of the spacer 105 is on the second surface S2, and the first surface S1 and the second surface S2 are different surfaces parallel to each other, that is, the spacer 105 can contact both the first surface S1 and the second surface S2. That is, the width of the spacer 105 protruding from the adjacent layer which is adjacent to the spacer 105 (the isolation layer 207) and is on the same one side of the substrate 101 as the spacer 105 is larger than the width of the part of the spacer 105 in the adjacent layer (the isolation layer 207), so that the pixel definition layer included in the color filter structure 100 can be more stably arranged on the substrate 101, thereby reducing or avoiding the risk that the pixel definition layer is peeled off from the substrate (which is the isolation layer 207).

For example, as shown in FIG. 34, a part of the spacers 105 is not disposed in the isolation layer opening area 207a, that is, the bottom surface of this part of the spacers 105 is located on the second surface S2.

For example, as shown in FIG. 34, the first sub-pixel 202, the second sub-pixel 203 and the third sub-pixel 204 are red sub-pixel, green sub-pixel and blue sub-pixel, respectively. The color control unit in the red sub-pixel includes red quantum dots, the color control unit in the green sub-pixel includes green quantum dots, the color control unit in the blue sub-pixel is blue color resistance layer, and the corresponding light-emitting elements of the plurality of light-emitting units 201 are blue organic light-emitting diode (OLED) devices.

For example, as shown in FIG. 34, the first sub-pixel 202, the second sub-pixel 203 and the third sub-pixel 204 are red sub-pixel, green sub-pixel and blue sub-pixel, respectively. The color control unit in the red sub-pixel includes red quantum dots, the color control unit in the green sub-pixel includes green quantum dots, and the color control unit in the blue sub-pixel includes blue quantum dots. The light-emitting elements corresponding to the plurality of light-emitting units 201 are purple organic light-emitting diode devices or ultraviolet organic light-emitting diode devices.

For example, as shown in FIG. 34, the display panel 200 further includes a reflection electrode 215 and a thin film transistor 208. The reflection electrode 215 can reflect the light emitted by the light-emitting unit to the base substrate 210, so as to improve the utilization rate of the emitted light. The reflection electrode 215 may be made of a metal material with a reflective function. The thin film transistor 208 is connected to the light-emitting element, such as an anode of an organic light-emitting diode, to provide a switching signal or a driving signal.

For example, as shown in FIG. 34, the display panel 200 further includes an encapsulation layer 212, a reflection polarizer 214, a color filter layer 209, a black matrix 213, and a cover film 211. The encapsulation layer 212 can protect other components in the display panel, and the cover film 211 can further protect other components in the display panel 200, and the reflection polarizer 209 can reflect the light emitted to the base substrate 210, so as to improve the utilization rate of the light.

For example, in FIG. 34, an isolation layer opening area 207a is on the side of the isolation layer 207 away from the base substrate 201, and an anchor portion 216 is formed in the isolation layer opening area 207a. In some embodiments, the anchor portion 216 is made of a conductive metal material; in some embodiments, the anchor portion 216 may be used as a metal electrode.

For example, FIG. 35 is a schematic cross-sectional structure diagram of another display panel provided by an embodiment of the present disclosure. As shown in FIG. 35, one part of the bottom of each of all the spacers 105 is located on the first surface S1 and the other part of the bottom of each of all the spacers 105 is located on the second surface S2. The first surface S1 and the second surface S2 are different surfaces parallel to each other, that is, the spacers 105 can be in contact with both the first surface S1 and the second surface S2. That is, the width of the part of the spacer 105 protruding from the adjacent layer (the isolation layer 207) which is adjacent to the spacer 105 and is on the same side of the substrate 101 as the spacer 105 is larger than the width of the part of the spacer 105 in the adjacent layer (the isolation layer 207), so that the pixel definition layer included in the color filter structure 100 can be more stably arranged on the substrate 101, thereby reducing or avoiding the risk that the pixel definition layer is peeled off from the substrate (the substrate is the isolation layer 207).

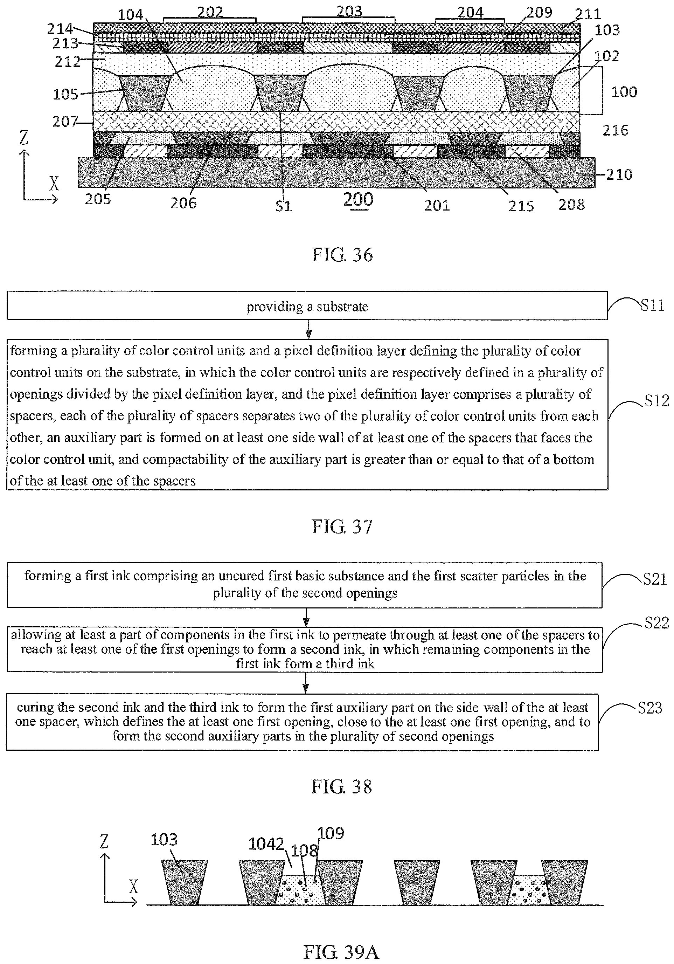

For example, FIG. 36 is a schematic cross-sectional structure diagram of another display panel provided by an embodiment of the present disclosure. As shown in FIG. 36, the entire bottom surface of each of the spacers 105 is located on the first surface S1.

At least one embodiment of the present disclosure further provides a preparation method of a color filter structure. FIG. 37 is a flowchart of a preparation method of the color filter structure provided by an embodiment of the present disclosure. As shown in FIG. 37, the preparation method includes the following steps.

Step S11: providing a substrate.

For example, the substrate may be an isolation layer, an encapsulation layer and so on.

Step S12: forming a plurality of color control units and a pixel definition layer defining the plurality of color control units on the substrate, in which the color control units are respectively defined in a plurality of openings divided by the pixel definition layer, and the pixel definition layer comprises a plurality of spacers, each of the plurality of spacers separates two of the plurality of color control units from each other, an auxiliary part is formed on at least one side wall of at least one of the spacers that faces the color control unit, and compactability of the auxiliary part is greater than or equal to that of a bottom of the at least one of the spacers.

For example, each of the plurality of spacers separates two of the plurality of color control units from each other, so that the phenomenon that light emitted by the plurality of color control units respectively do not cross talk can be realized, and thus the uniformity of light mixing can be improved.

For example, the compactability of the auxiliary part is greater than or equal to the compactability of the surface of the spacer which is in contact with the adjacent layer which is on the same side of the substrate side as the spacer, which can reduce or prevent a part of the raw materials of the color control unit from entering the adjacent opening.

For example, the auxiliary part is in contact with the first surface of an adjacent layer which is on the same side of the substrate as the auxiliary part, and the spacer is in contact with the second surface of an adjacent layer which is on the same side of the substrate as the spacer. The first surface and the second surface are the same surface, so that the auxiliary part can be directly formed on the adjacent layer of the auxiliary part without forming an opening in the adjacent layer of the auxiliary part on the same side of the substrate as the auxiliary part to accommodate a part of the auxiliary part.

Or, the plane where the first surface is located and the plane where the second surface is located are different planes parallel to each other, but this design requires an opening to be formed in the adjacent layer of the auxiliary part to accommodate a part of the auxiliary part.

For example, the auxiliary part is in contact with the first surface of the adjacent layer which is on the same side of the substrate as the auxiliary part, and the spacer is in contact with the second surface of the adjacent layer which is on the same side of the substrate as the spacer. Please refer to the relevant descriptions in FIG. 3, which is not omitted herein.

For example, in one example, the auxiliary part is a light-transmissive structure, and the auxiliary part includes a first basic substance which is light-transmissive and first scatter particles, and the first scatter particles are distributed in the first basic substance.

For example, the first basic substance includes a transparent resin, the transparent resin is an ultraviolet light curable resin, and the material of the first scatter particles includes a transparent metal oxide, and the transparent metal oxide includes titanium oxide or silicon oxide.

For example, in one example, the material of the auxiliary part is the same as that of the first basic substance, that is, there may be no first scatter particle in the auxiliary part, and the light incident on the auxiliary part may not be scattered.

For example, the color control units include a first color control unit, the openings include a first opening, and the first color control unit is defined in the first opening divided by the pixel definition layer; the first color control unit includes color conversion particles configured to convert light with a first wavelength into light with a second wavelength.

For example, the first wavelength light has a wavelength smaller than that of the second wavelength light, and the first wavelength light has higher energy than the second wavelength light.

For example, the color conversion particles include quantum dots, which include red quantum dots R and green quantum dots G Correspondingly, the first color control unit includes a red control unit and a green control unit.

For example, the color control units further include a second color control unit, and the openings further include a second opening. The second color control unit is defined in the second opening divided by the pixel definition layer, and the second color control unit is used for transmitting the light with the first wavelength that enters the second color control unit, that is, the second color control unit does not convert the light with the first wavelength.

For example, the second color control unit includes a second basic substance which is light-transmissive, and in the case where the backlight emits blue light, the second color control unit is a blue control unit.

The first basic substance and the second basic substance may be the same or different. In the case where the first basic substance and the second basic substance are the same, the preparation process can be simplified, and the first basic substance and the second basic substance have the same refractive index.

For example, the second basic substance includes a transparent resin, and the transparent resin is an ultraviolet curable resin.

For example, the material of the second scattering particles includes a transparent metal oxide, and the transparent metal oxide includes titanium oxide or silicon oxide.

For example, the second color control unit may or may not include second scatter particles, and in the case where the second color control unit includes the second scatter particles, the second scatter particles are distributed in the second basic substance. In the case where the second color control unit does not include the second scatter particles, the second color control unit may only transmit the light incident therein.

For example, the material of the auxiliary part adjacent to the second color control unit includes the first scatter particles dispersed in the first basic substance, the material of the first scatter particles are the same as the second scatter particles, and the mass percentage of the second scatter particles in the second color control unit is smaller than that of the first scatter particles in the auxiliary part adjacent to the second color control unit. Alternatively, the material of the auxiliary part adjacent to the second color control unit includes the first scatter particles dispersed in the first basic substance, and the second color control unit does not include the scatter particles, that is, the second color control unit does not include the first scatter particles or the second scatter particles.

For example, in the case where the auxiliary part is only in the first opening, the refractive index of the auxiliary part in the first opening is smaller than that of the first color control unit, so that when the light with the first wavelength emitted by the backlight enters the first color control unit in the first opening and is converted into light with the second wavelength in the first color control unit, the light with the second wavelength is refracted at the interface where the first color control unit contacts the auxiliary part, the light is in a dispersed state, so that less light is absorbed by the opaque spacer, thereby enhancing the intensity of the light emitted from the first color control unit. Although the intensity of the light with the first wavelength emitted from the second color control unit is constant, the uniformity of color mixing can be improved to some extent.

For example, in the case where the auxiliary part is only in the second opening, the refractive index of the auxiliary part is larger than that of the second color control unit. In this way, when the light with the first wavelength emitted by the backlight enters the second color control unit, and the light with the first wavelength is refracted at the contact interface between the second color control unit and the auxiliary part, the light is in a state of being gathered, so that more light is absorbed by the opaque spacer, and the intensity of the light emitted from the second color control unit is weakened. Although the intensity of the light with the second wavelength emitted from the first color control unit is constant, the uniformity of color mixing can be improved to some extent.

For example, in the case where the auxiliary parts are in both the first opening and the second opening, the refractive index of the auxiliary part in the first opening is smaller than that of the first color control unit, and the refractive index of the auxiliary part in the second opening is larger than that of the second color control unit, when the light with the first wavelength emitted by the backlight enters the first color control unit and is converted into the light with the second wavelength in the first color control unit, and when the light with the second wavelength is refracted at the interface between the first color control unit and the auxiliary part, the light is in a dispersed state, so that less light is absorbed by the opaque spacer, and the intensity of the light emitted from the first color control unit is enhanced. For example, the first color control unit is at least one selected from a group consisting of a red control unit and a green control unit. The refractive index of the auxiliary part adjacent to the second color control unit is larger than that of the second color control unit, so that when the light with the first wavelength emitted by the backlight enters the second color control unit and the light with the first wavelength is refracted at the interface between the second color control unit and the auxiliary part, the light is in a gathered state, so that more light is absorbed by the opaque spacer, thereby weakening the intensity of the light emitted from the second color control unit. In this way, by adjusting the refractive index relationship between the auxiliary part and the corresponding color control unit, the intensity of the light with the second wavelength, which is originally weak, can be enhanced, while the intensity of the light with the first wavelength, which is originally strong, can be weakened, and thus the light mixing can be uniform, thereby improving the color gamut.

For example, in the case where the auxiliary parts are in both the first opening and the second opening, the refractive index of the auxiliary part located in the first opening is equal to that of the first color control unit, and the refractive index of the auxiliary part located in the second opening is larger than that of the second color control unit, although the intensity of the light emitted from the first color control unit is not enhanced, the intensity of the light emitted from the second color control unit is weakened, and the intensity of the light with the first wavelength which is originally strong, can also be weakened, and thus the light mixing can be uniform, thereby improving the color gamut.

For example, in the case where the auxiliary parts are in the first opening and the second opening, the refractive index of the auxiliary part located in the first opening is smaller than that of the first color control unit, and the refractive index of the auxiliary part located in the second opening is equal to that of the second color control unit, although the intensity of the light emitted from the second color control unit is not weakened, the intensity of the light emitted from the first color control unit is enhanced, so that the intensity of the light with the second wavelength, which is originally weak, can also be enhanced, and thus the light mixing can be uniform, thereby improving the color gamut.

For example, both the first auxiliary part and the second auxiliary part only include the first basic substance. By adjusting the refractive indexes of the first color control unit and the second color control unit, it is satisfied that the light with the first wavelength emitted from the second opening is weakened, and the light with the second wavelength emitted from the first opening is enhanced, so that the light mixture is more uniform.

For example, in the case where the auxiliary parts are in both the first opening and the second opening, the auxiliary part adjacent to the second color control unit is the first auxiliary part, and the auxiliary part located in the second opening is the second auxiliary part, and the refractive index of the first auxiliary part is smaller than that of the second auxiliary part. The first auxiliary part includes, for example, a first basic substance and first scatter particles, and the second auxiliary part includes a second basic substance and the first scatter particles, the first basic substance and the second basic substance may be the same or different. For example, the mass percentage of the first scatter particles in the first auxiliary part is smaller than that in the second auxiliary part.

For example, in one embodiment of the present disclosure, the first auxiliary part and the second auxiliary part are formed in a same process step. FIG 38 is a flowchart of forming a first auxiliary part and a second auxiliary part provided by an embodiment of the present disclosure. As shown in FIG 38, the preparation method includes the following steps:

Step S21: forming a first ink comprising an uncured first basic substance and the first scatter particles in the plurality of the second openings;
Step S22: allowing at least a part of components in the first ink to permeate through at least one of the spacers to reach at least one of the first openings to form a second ink, in which remaining components in the first ink form a third ink;

Step S23: curing the second ink and the third ink to form the first auxiliary part on the side wall of the at least one spacer, which defines the at least one first opening, close to the at least one first opening, and to form the second auxiliary parts in the plurality of second openings.

For example, the meaning of the description "at least a part of components in the first ink" may include only the uncured first basic substance in the first ink, or the first basic substance in the first ink and the first scatter particles in the first ink.

For example, FIG 39A to FIG 39C are process diagrams of forming the first auxiliary part and the second auxiliary part provided by an embodiment of the present disclosure, and FIG 39A to FIG 39C illustrate that the pixel definition layer is formed before the auxiliary part, and the pixel definition layer may be formed after the auxiliary part is formed in some other embodiments.

As shown in FIG 39A, the first ink including the uncured first basic substance 108 and the first scatter particles 109 is formed in the plurality of second openings 1042 included in the pixel definition layer 103.

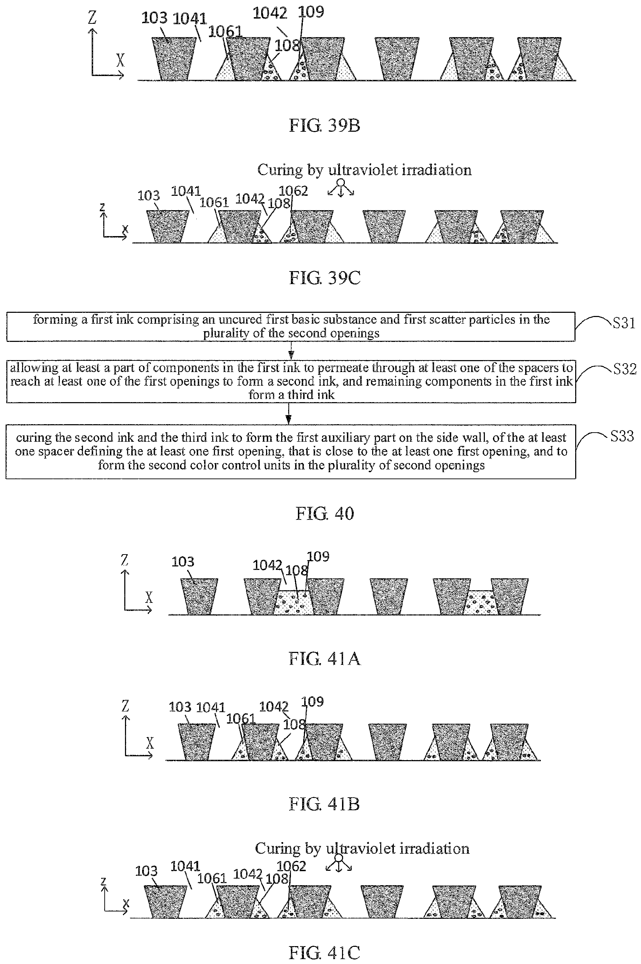

As shown in FIG 39B, at least a part of components in the first ink permeate through at least one spacer 108 to reach at least one first opening 1041 to form the second ink, and the remaining components in the first ink form the third ink.

For example, the meaning of the description "at least a part of components in the first ink" may include only the uncured first basic substance in the first ink, or the first basic substance in the first ink and the first scatter particles in the first ink.

As shown in FIG 39C, the second ink and the third ink are cured to form the first auxiliary part 1061 on the side wall of at least one spacer 105 defining the at least one first opening 1041, and the second auxiliary part 1062 in the plurality of second openings 1042.

For example, as shown in FIG 39C, the first auxiliary part 1061 does not include the first scatter particles 109, but the second auxiliary part 1062 includes the first scatter particles 109, and the second auxiliary part 1062 can be formed without special process steps, thus saving the production cost.

For example, the first auxiliary part 1061 and the second auxiliary part 1062 are described by taking the case where the cross-sectional shapes of both the first auxiliary part 1061 and the second auxiliary part 1062 are triangular as an example. The cross-sectional shapes of the first auxiliary part 1061 and the second auxiliary part 1062 may be the same or different, and the cross-sectional shapes of the first auxiliary part 1061 and the second auxiliary part 1062 may be in a shape similar to a triangle with an arc side line which is away from the adjacent spacer 105, or in a shape similar to a triangle with a stepped side line away from the adjacent spacer 105, which are not limited in the present disclosure.

For example, in one embodiment of the present disclosure, the first auxiliary part and the second auxiliary part are formed in a same process step. FIG 40 is another flowchart of forming a first auxiliary part and a second auxiliary part provided by an embodiment of the present disclosure. As shown in FIG 40, the preparation method includes the following steps:

Step S31: forming a first ink comprising an uncured first basic substance and first scatter particles in the plurality of the second openings.

Step S32: allowing at least a part of components in the first ink to permeate through at least one of the spacers to reach at least one of the first openings to form a second ink, and remaining components in the first ink form a third ink.

Step S33: curing the second ink and the third ink to form the first auxiliary part on the side wall, of the at least one spacer defining the at least one first opening, that is close to the at least one first opening, and to form the second color control units in the plurality of second openings.

For example, the meaning of the description "at least a part of components in the first ink" may include only the uncured first basic substance in the first ink, or the first basic substance in the first ink and the first scatter particles in the first ink.

For example, FIG 41A to FIG 41C are process diagrams of forming the first auxiliary part and the second auxiliary part provided by an embodiment of the present disclosure, and FIG 41A to FIG 41C illustrate that the pixel definition layer is formed before the auxiliary part, and the pixel definition layer may be formed after the auxiliary part is formed in some other embodiments.

As shown in FIG 41A, the first ink including the uncured first basic substance 108 and the first scatter particles 109 is formed in the plurality of second openings 1042 included in pixel definition layer 103.

As shown in FIG 41B, at least a part of components in the first ink permeate through at least one spacer 105 to at least one first opening 1041 to form the second ink, and the remaining components in the first ink form the third ink.

For example, the meaning of the description "at least a part of components in the first ink" may include only the uncured first basic substance in the first ink, or the first basic substance in the first ink and the first scatter particles in the first ink.

As shown in FIG 41C, the second ink and the third ink are cured to form the first auxiliary part 1061 on the side wall of at least one spacer 105 defining the at least one first opening 1041, and to form the second auxiliary part 1062 in the plurality of second openings 1042.

For example, both the first auxiliary part 1061 and the second auxiliary part 1062 include the first basic substance 108 and the first scatter particles 109 dispersed in the first basic substance 108. The mass percentage of the first scatter particles 109 in the first auxiliary part 1061 is smaller than that in the second auxiliary part 1062, so that no additional process steps are needed to form the first auxiliary part 1061.

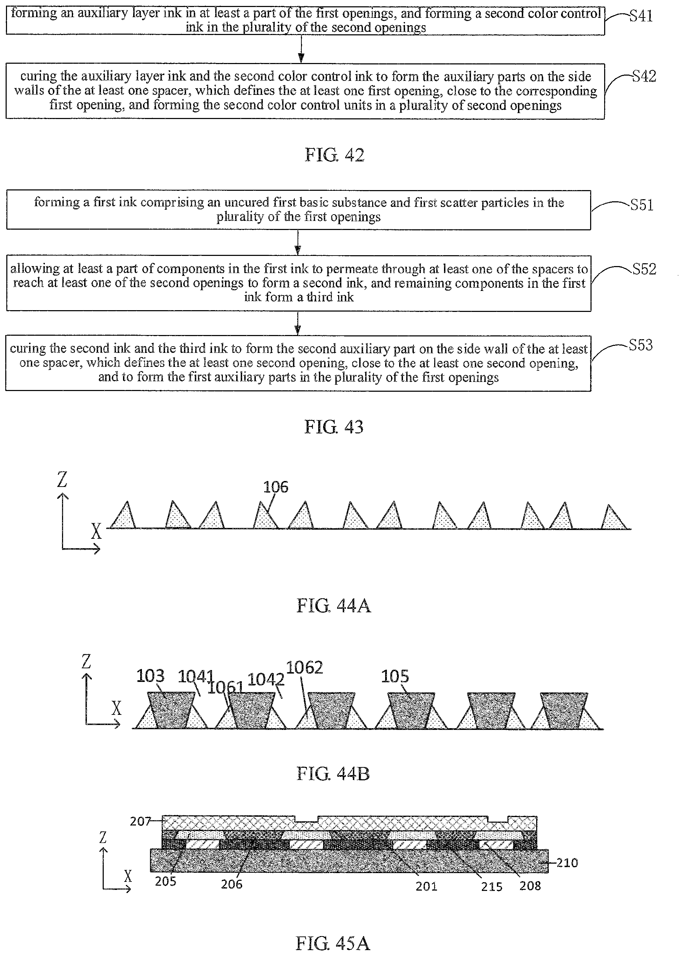

For example, in at least one embodiment of the present disclosure, the second color control units and the auxiliary parts in the plurality of second openings are formed in a same process step. For example, FIG 42 is a flowchart of forming a second color control unit and an auxiliary part provided by an embodiment of the present disclosure. As shown in FIG 42, forming the second color control units and the auxiliary parts includes:

Step S41: forming an auxiliary layer ink in at least a part of the first openings, and forming a second color control ink in the plurality of the second openings.

For example, the auxiliary layer ink and the second color control ink are the same or different, for example, they may be the same resin material, or the same kind of first scatter particles may be dispersed in the same resin material.

Step S42: curing the auxiliary layer ink and the second color control ink to form the auxiliary parts on the side walls of the at least one spacer, which defines the at least one first opening, close to the corresponding first opening, and forming the second color control units in a plurality of second openings.

For example, the auxiliary layer ink and the second color control ink both include a resin material, and the resin material is an ultraviolet curable resin.

For example, FIG 43 is a flowchart of forming the second color control units and the auxiliary parts provided by another embodiment of the present disclosure. As shown in FIG 43, forming the second color control units and the auxiliary parts includes:

Step S51: forming a first ink comprising an uncured first basic substance and first scatter particles in the plurality of the first openings.

Step S52: allowing at least a part of components in the first ink to permeate through at least one of the spacers to reach at least one of the second openings to form a second ink, and remaining components in the first ink form a third ink.

For example, the raw material of the second auxiliary part to be formed and the raw material of the second color control unit to be formed both include the first basic substance and the first scatter particles. The raw material of the first auxiliary part to be formed only include the first basic substance, and only the first ink is formed in the second opening, the first ink is not applied in the first opening, the first basic substance in the second opening can enter the first opening by diffusion, thus increasing the mass percentage of the first scatter particles in the first basic substance of the auxiliary part to be formed.

For example, the meaning of the description "at least a part of components in the first ink" may include only the uncured first basic substance in the first ink, or the first basic substance in the first ink and the first scatter particles in the first ink.

Step S53: curing the second ink and the third ink to form the second auxiliary part on the side wall of the at least one spacer, which defines the at least one second opening, close to the at least one second opening, and to form the first auxiliary parts in the plurality of the first openings.

For example, the first basic substance is an ultraviolet curable resin, and the second ink and the third ink can be cured by ultraviolet irradiation to form corresponding structures.

Of course, in other examples, it may be divided into two steps, namely, applying the first ink having the first basic substance and the first scatter particles in the plurality of second openings, corresponding to the first auxiliary part and the second auxiliary part to be formed; and then, after performing a curing process to form the first auxiliary part and the second auxiliary part, applying the first basic substance and the first scatter particles into the second openings, and then performing a curing process to form the second color control unit.

In other examples, it may be divided into two steps, namely, applying the first ink with the first basic substance and the first scatter particles in the plurality of second openings, corresponding to the first auxiliary part and the second auxiliary part to be formed; and then, after performing a curing process to form the first auxiliary part and the second auxiliary part, applying the second basic substance and the second scatter particles or only applying the second basic substance into the second openings, and then performing a curing process to form the second color control unit.

For example, in one example, the material of the spacer is a heat curable resin, the material of the auxiliary part is an ultraviolet curable resin, and the auxiliary part is formed by inkjet printing.

For example, the process of forming the auxiliary part by ink-jet printing includes: forming an ultraviolet curable resin in the opening, and curing the material of the auxiliary part by ultraviolet light after pre-infiltration, and before pre-infiltration, the volume of the ultraviolet curable resin is 90% to 120% of the accommodating space of the opening, for example, the volume of the ultraviolet curable resin is 90%, 100%, 110% or 120% of the accommodating space of the opening.

In some examples, a part of the ultraviolet curable resin is formed outside the top of the opening so that the outermost surface of the ultraviolet curable resin is outward convex arc, and because the spacer is hydrophobic, the ultraviolet curable resin does not spread out, but the ultraviolet curable resin at the lower end of the opening continuously permeates into the adjacent openings, so that the amount of ultraviolet curable resin in the opening decreases continuously, and the surface of the ultraviolet curable resin away from the substrate in the opening is located in the opening.

For example, the ultraviolet curable resin is a resin material containing nanoparticles, the viscosity of the ultraviolet curable resin at the room temperature is in a range of 5 cps to 12cps, and the surface tension of the ultraviolet curable resin is in a range of 30 mN/m -35 mN/m.

For example, the viscosity of the ultraviolet curable resin at the room temperature is 5cps, 6cps, 7cps, 8cps, 9cps, 10cps, 11cps or 12cps, and the surface tension is 30mN/m, 31mN/m, 32mN/m, 34mN/m or 35 N/m.

For example, the material of the spacer is a heat curable resin, the material of the auxiliary part is titanium oxide or silicon oxide, the auxiliary part is formed by photolithography, and the auxiliary part is formed before or after the spacer is formed.

For example, in the embodiment of the present disclosure, the auxiliary part may be formed by photolithography first, and then the openings and spacers included in the pixel definition layer may be formed.

For example, FIG 44A to FIG 44B are diagrams of a process of forming an auxiliary part and a spacer provided by an embodiment of the present disclosure. As shown in FIG 44A, the material of the auxiliary part is applied on the substrate, and then the auxiliary part is formed by photolithography. As shown in FIG 44B, the pixel definition layer 103 is formed on the substrate. The pixel definition layer 103 includes a spacer 105, a first opening 1041 and a second opening 1042, the first auxiliary part 1061 is in the first opening and the second auxiliary part 1062 is in the second opening.

For example, at least one embodiment of the present disclosure further provides a preparation method of a display panel, for example, FIG 45A to FIG 45I are process diagrams of preparing the display panel provided by an embodiment of the present disclosure.

For example, as shown in FIG 45A, a reflection electrode 215 and a thin film transistor 208 are formed on a base substrate 210. The reflection electrode 215 can reflect the light emitted by the light-emitting unit to a base substrate 210, so as to improve the utilization rate of the emitted light. The reflection electrode 215 can be made of a metal material with a reflective function. The thin film transistor 208 is connected to the light-emitting element, such as an anode of an organic light-emitting diode, to provide a switching signal or a driving signal.

For example, as shown in FIG 45A, a light-emitting unit definition layer 205 is formed on the layer where the reflection electrode 215 and the thin film transistor 208 are located, and the light-emitting unit definition layer 205 includes a plurality of pixel openings 206, the plurality of light-emitting units 201 are arranged in the plurality of pixel openings 206 in one-to-one correspondence, and an orthographic projection of each of the pixel openings 206 is located within the orthographic projection of the corresponding opening 104. The light-emitting unit definition layer 205 separates the adjacent light-emitting units 201, so that the intensity of the light with the first wavelength entering each of the openings of the pixel definition layer formed later is the same, which can ensure the uniformity of light emission.

For example, as shown in FIG 45A, an isolation layer 207 is formed on the light-emitting unit definition layer 205 and the light-emitting units 201, and the plurality of light-emitting units 201 are separated from the subsequently formed color filter structure by the isolation layer 207, and the isolation layer 207 may be an interlayer insulation layer or an encapsulation layer.

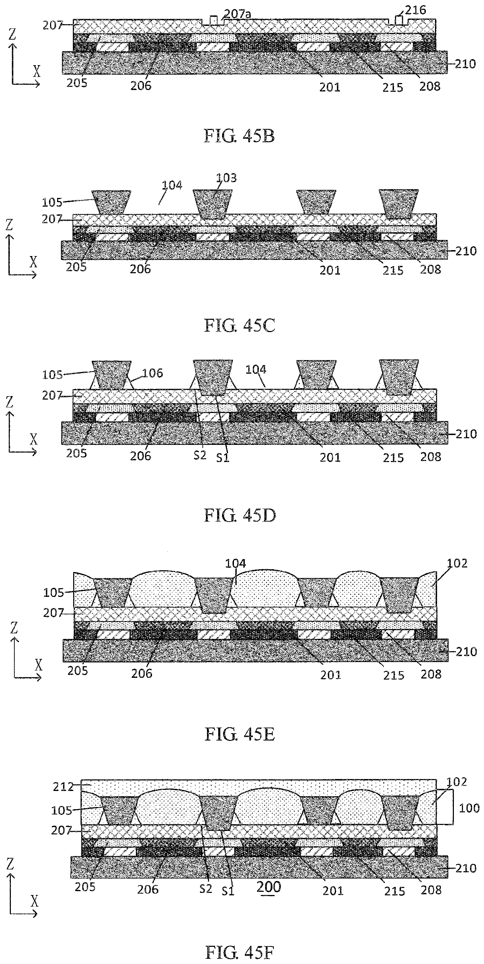

For example, as shown in FIG 45B, an isolation layer opening area 207a is on the side of the isolation layer 207 away from the base substrate 201, and an anchor part 216 is formed in the isolation layer opening area 207a, the anchor part 216 is made of a conductive metal material and can be used as a metal electrode.

For example, as shown in FIG 45C, the pixel definition layer 103 is formed on the isolation layer 207. The pixel definition layer 103 includes a plurality of openings 104 and a plurality of spacers 105. At least a part of at least one spacer 105 is formed in the isolation layer opening area 207a, and the other part of the spacer 105 is not formed in the isolation layer opening area 207a, that is, the bottom surfaces of adjacent spacers 105 are located in different planes, the spacer 105 located in the isolation layer opening area 207a can reduce or avoid the risk that the pixel definition layer 103 is peeled off from the isolation layer 207. The spacer 105 may be the substrate included in the subsequently formed color filter structure 100.

For example, the material of the isolation layer 207 is a transparent material, so that the light emitted by the light-emitting unit 201 can be incident into the corresponding opening 104.

For example, as shown in FIG 45D, an auxiliary part 106 is formed in the opening 104, and the arrangement of the auxiliary part 106 can be referred to the related description of the above-mentioned color filter structure 100, which is omitted herein.

For example, as shown in FIG 45D, for the spacer 105 formed in the isolation layer opening area 207a, a part of the bottom of the spacer 105 is on the first surface S1 and the other part of the spacer 105 is on the second surface S2. The first surface S 1 and the second surface S2 are different surfaces parallel to each other, that is, the spacer 105 can contact with both the first surface S 1 and the second surface S2. That is, the width of the part of the spacer 105 protruding from the adjacent layer (the isolation layer 207) which is adjacent to the spacer 105 and is on the same side of the substrate 101 as the spacer 105, is larger than the width of the part of the spacer 105 in the adjacent layer (the isolation layer 207), so that the pixel definition layer 103 can be more stably arranged on the substrate 101, thereby reducing or avoiding the risk that the pixel definition layer 103 is peeled off from the substrate (which is the isolation layer 207). For the spacer 105 not formed in the isolation layer opening area 207a, the bottom surface of the spacer 105 is located on the second surface S2.

For example, as shown in FIG 45E, a color control unit 102 is formed in an opening 104, the plurality of color control units 102 are respectively defined in the plurality of openings 104 divided by the pixel definition layer 103, and each of the plurality of spacers 105 separates two of the plurality of color control units 102 from each other.

The related descriptions of the color control unit 102 can be found in the above descriptions, which is omitted herein.

For example, as shown in FIG 45F, an encapsulation layer 212 is formed on the color control unit 102, and the material of the encapsulation layer 212 may be an organic insulation material, an inorganic insulation material, or a laminate of an organic insulation material and an inorganic insulation material, which is not limited in the embodiment of the present disclosure.

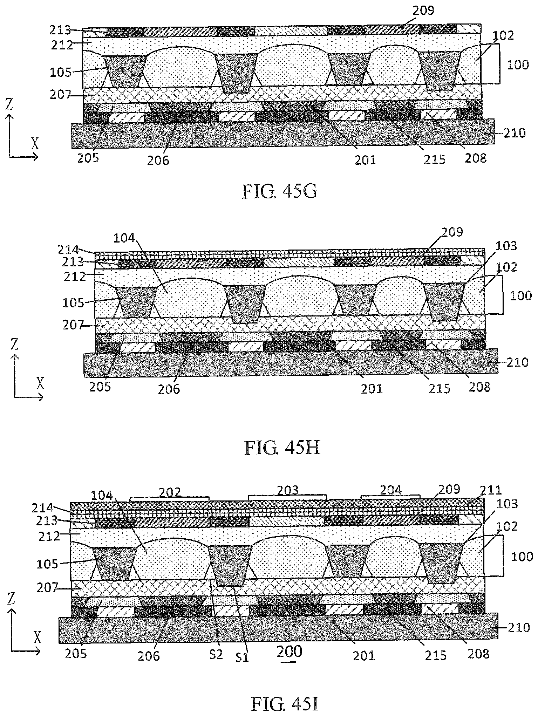

For example, as shown in FIG 45G, a color filter layer 209 and a black matrix 213 are formed on the encapsulation layer 212, and the color filter layer 209 and the black matrix 213 can refer to conventional designs, which are not limited in the embodiments of the present disclosure.

For example, as shown in FIG 45H, a reflection polarizer 214 is formed on the color filter layer 209 and the black matrix 213. The reflection polarizer 214 can reflect the ambient light to avoid the influence of the ambient light.

For example, an organic protection layer material (OC) may be used instead of the reflection polarizer 214 to reflect the ambient light.

For example, as shown in FIG 45I, a cover film 211 is formed on the reflection polarizer 214, the cover film 211 can prevent the outside from causing mechanical damage to the display panel. For other descriptions of the display panel 200, please refer to the above descriptions of FIG 33, which is omitted herein.

For example, in the case where the auxiliary part is formed by photolithography, the auxiliary part may be formed first, and then the spacer is formed. The difference between the forming process and that shown in FIG 45A to FIG 45I is that the order of FIG 45C and FIG 45D is reversed in the forming process.

The color filter structure, the preparation method of the color filter structure and the display panel provided by at least one embodiment of the present disclosure have at least one of the following beneficial effects:

(1) In the color filter structure provided by at least one embodiment of the present disclosure, the compactability of the auxiliary part is greater than or equal to that of the bottom of the spacer, which is equivalent to improve the compactability of the bottom of the spacer, so that the subsequent ink which is in a flowing state can be prevented from permeating into the adjacent openings, thereby avoiding causing the cross-color problem and affecting the display effect.

(2) In the color filter structure provided by at least one embodiment of the present disclosure, the refractive index of the auxiliary part adjacent to the first color control unit is smaller than that of the first color control unit, so that when the light with the first wavelength emitted by the backlight enters the first color control unit, and in the first color control unit the light with the first wavelength is converted into the light with the second wavelength, the light with the second wavelength entering the auxiliary part from the first color control unit can be dispersed, thus, the intensity of the light emitted from the first color control unit is enhanced.

(3) In the color filter structure provided by at least one embodiment of the present disclosure, the refractive index of the auxiliary part adjacent to the second color control unit is higher than that of the second color control unit, so that when the light with the first wavelength emitted by the backlight enters the second color control unit, the light with the first wavelength entering the auxiliary part from the second color control unit can be gathered, thereby weakening the intensity of the light emitted from the second color control unit.

The following statements should be noted:

(1) The accompanying drawings involve only the structure(s) in connection with the embodiment(s) of the present disclosure, and other structure(s) can be referred to common design(s).

(2) For the purpose of clarity, in accompanying drawings for illustrating the embodiment(s) of the present disclosure, the thickness of a layer or a region may be enlarged or narrowed, that is, the drawings are not drawn in a real scale. It should understood that, in the case that a component such as a layer, a film, a region, a substrate or the like is referred to be "on" or "under" another component, and the component may be directly on or under the another component or there may be an intermediate component.

(3) In a case of no conflict, the embodiments of the present disclosure and the features in the embodiments can be combined with each other to obtain new embodiments.

What have been described above are only specific implementations of the present disclosure, the protection scope of the present disclosure is not limited thereto, and the protection scope of the present disclosure should be based on the protection scope of the claims.

## Claims

1. A color filter structure, comprising:

a plurality of color control units on a substrate, and a pixel definition layer defining the plurality of color control units,

wherein the plurality of color control units are respectively defined in a plurality of openings divided by the pixel definition layer;

the pixel definition layer comprises a plurality of spacers, each of the plurality of spacers separates two of the plurality of color control units from each other;

an auxiliary part is on at least one side wall of at least one of the spacers that faces one of the color control units corresponding to the at least one of the spacers;

compactability of the auxiliary part is greater than or equal to that of a bottom of the at least one of the spacers.

2. The color filter structure according to claim 1, wherein the compactability of the auxiliary part is greater than or equal to compactability of a surface of the at least one of the spacers in contact with an adjacent layer which is adjacent to the at least one of the spacers and is on a side close to the substrate.

3. The color filter structure according to claim 1 or 2, wherein the auxiliary part is in contact with a first surface of its adjacent layer at a side close to the substrate, and the at least one of the spacers is in contact with a second surface of its adjacent layer at the side close to the substrate;

the first surface and the second surface are a same surface; or,
a plane where the first surface is located and a plane where the second surface is located are different planes parallel to each other.

4. The color filter structure according to claim 3, wherein the auxiliary part has a third surface in contact with the first surface and a fourth surface in contact with the at least one of the spacers;

a contour of the third surface is complementary to a contour of the first surface, and a contour of the fourth surface is complementary to a contour of a position that the fourth surface is in contact with the at least one of the spacers; and the third surface and the fourth surface are in contact with each other at a junction of the first surface and the at least one side wall of the at least one of the spacers, and the auxiliary part has a fifth surface in contact with the one of the color control units corresponding to the at least one of the spacers.

5. The color filter structure according to claim 4, wherein the auxiliary part has a first cross-section in a direction perpendicular to a main surface of the substrate, and a first cut-off line segment of the first cross-section is obtained by intercepting in a direction from a position away from the first surface to a position close to the first surface, a length of the first cut-off line segment is negatively related to a distance from the first cut-off line segment to the first surface.

6. The color filter structure according to claim 4, wherein the auxiliary part has a first cross-section in a direction perpendicular to a main surface of the substrate, and a first cut-off line segment of the first cross-section is obtained in a direction from a position away from the first surface to a position close to the first surface, a length of the first cut-off line segment gradually decreases with increase of a distance from the first cut-off line segment to the first surface.

7. The color filter structure according to claim 5, wherein in a shape of the first cross-section of the auxiliary part in the direction perpendicular to the main surface of the substrate, the fifth surface has a corresponding first cut-off contour line, and the first cut-off contour line is one selected from a group consisting of a straight line segment, a curved line segment or a Z-shaped line.

8. The color filter structure according to claim 7, wherein in a case where the first cut-out contour line is the curved line segment, the curved line segment is recessed toward inside of the auxiliary part.

9. The color filter structure according to claim 3, wherein the spacer has a second cross-section in a direction perpendicular to a main surface of the substrate, with a straight line which is parallel to the substrate and passes through a farthest point away from the substrate of a shape of the second cross-section as a first boundary, and with a straight line formed by connecting two contact ends, of positions of the shape of the second cross-section where the second cross-section is in contact with the first surface, that are closest to the color control units as a second boundary, and with straight lines which respectively pass through the two contact ends and extend to the first boundary and circumscribe the shape of the second cross-section as a third boundary and a fourth boundary, in a quadrilateral surrounded by the first boundary, the second boundary, the third boundary and the fourth boundary,

a line segment of the quadrilateral intercepted at the first boundary is a first side line,
a line segment of the quadrilateral intercepted at the second boundary is a second side line,
a line segment of the quadrilateral intercepted at the third boundary is a third side line,

a line segment of the quadrilateral intercepted at the fourth boundary is a fourth side line, wherein a length of the first side line is greater than a length of the second side line.

10. The color filter structure according to claim 9, wherein the length of the first side line is equal to 1.2 to 4 times the length of the second side line.

11. The color filter structure according to claim 3, wherein a maximum thickness of the auxiliary part in a direction perpendicular to a main surface of the substrate is greater than or equal to half of a thickness of a part of the spacer that is higher than the first surface and less than the thickness of the part of the spacer that is higher than the first surface.

12. The color filter structure according to claim 1 or 2, wherein the auxiliary part is an opaque structure.

13. The color filter structure according to claim 12, wherein the auxiliary part is made of a material of at least one selected from a group consisting of a black resin material and a metal material.

14. The color filter structure according to claim 13, wherein the metal material comprises one or more selected from a group consisting of gold, silver, aluminum, copper and molybdenum.

15. The color filter structure according to claim 1 or 2, wherein the auxiliary part is a light-transmissive structure.

16. The color filter structure according to claim 15, wherein the auxiliary part comprises a light-transmissive first basic substance and first scatter particles, and the first scatter particles are distributed in the first basic substance.

17. The color filter structure according to claim 16, wherein the first basic substance comprises a transparent resin; a material of the first scatter particles comprises a transparent metal oxide.

18. The color filter structure according to claim 15, wherein the color control units comprise a first color control unit, and the openings comprise a first opening, and the first color control unit is defined in the first opening divided by the pixel definition layer; and the first color control unit comprises color conversion particles, and the color conversion particles are configured to convert light with a first wavelength into light with a second wavelength.

19. The color filter structure according to claim 18, wherein the color conversion particles comprise a red quantum dot or a green quantum dot.

20. The color filter structure according to claim 18, wherein the color control units further comprise a second color control unit, and the openings further comprise a second opening, and the second color control unit is defined in the second opening divided by the pixel definition layer; the second color control unit is configured to transmit light with the first wavelength entering the second color control unit with the first wavelength.

21. The color filter structure according to claim 20, wherein the second color control unit comprises a light-transmissive second basic substance; and the second color control unit comprises second scatter particles distributed in the second basic substance.

22. The color filter structure according to claim 21, wherein the second basic substance comprises a transparent resin, and a material of the second scatter particles comprises a transparent metal oxide.

23. The color filter structure according to claim 22, wherein the first basic substance is the same as the second basic substance.

24. The color filter structure according to claim 21, wherein a material of the auxiliary part adjacent to the second color control unit comprises the first scatter particles dispersed in the first basic substance, a material of the first scatter particles is same as that of the second scatter particles, and a mass percentage of the second scatter particles in the second color control unit is smaller than that of the first scatter particles in the auxiliary part adjacent to the second color control unit.

25. The color filter structure according to any one of claims 20 to 24, wherein the second opening is disposed adjacent to at least one of the first openings.

26. The color filter structure according to claim 25, wherein the auxiliary part in the first opening is a first auxiliary part, and the auxiliary part in the second opening is a second auxiliary part, both the first auxiliary part and the second auxiliary part comprise the first basic substance and the first scatter particles dispersed in the first basic substance, and a mass percentage of the first scatter particles in the first auxiliary part is less than a mass percentage of the first scatter particles in the second auxiliary part.

27. The color filter structure according to claim 1 or 2, wherein in a case where the auxiliary part is in the first opening, a refractive index of the auxiliary part is smaller than that of the first color control unit.

**28.** The color filter structure according to claim 20, wherein

in a case where the auxiliary part is only in the first opening, a refractive index of the auxiliary part is smaller than that of the first color control unit;

in a case where the auxiliary part is only in the second opening, the refractive index of the auxiliary part is larger than that of the second color control unit;

in a case where the auxiliary part is in both the first opening and the second opening, the refractive index of the auxiliary part in the first opening is less than or equal to that of the first color control unit, and the refractive index of the auxiliary part in the second opening is greater than that of the second color control unit, or, the refractive index of the auxiliary part in the first opening is smaller than that of the first color control unit, and the refractive index of the auxiliary part in the second opening is equal to that of the second color control unit.

**29.** The color filter structure according to claim 28, wherein the first auxiliary part and the second auxiliary part each comprise only the first basic substance.

**30.** The color filter structure according to claim 1 or 2, wherein a contact angle of the spacers with propylene glycol methyl ether acetate is greater than or equal to 40 degrees, and a contact angle of the auxiliary part with water is less than or equal to 20 degrees.

**31.** The color filter structure according to claim 1 or 2, wherein a contact angle of the spacers with water is greater than or equal to 90 degrees, and a contact angle of the auxiliary part with water is less than or equal to 50 degrees.

**32.** The color filter structure according to claim 1 or 2, wherein a material of the spacers comprises heat curable resin.

**33.** The color filter structure according to claim 1 or 2, wherein the plurality of spacers are distributed in an array;

along a row direction, one of the at least one side wall of each of the spacers is provided with the auxiliary part;

along a column direction, one of the at least one side wall of each of the spacers is provided with the auxiliary part.

**34.** The color filter structure according to claim 33, wherein the plurality of spacers are distributed in an array,

along the row direction, the auxiliary parts are respectively on two opposite side walls of a same spacer of the plurality of spacers, or, the auxiliary parts are respectively on the side walls closest to each other of two adjacent spacers of the plurality of spacers;

along the column direction, the auxiliary parts are respectively on two opposite side walls of a same spacer of the plurality of spacers, or the auxiliary parts are respectively on the side walls closest to each other of two adjacent spacers of the plurality of spacers.

**35.** The color filter structure according to claim 34, wherein in a case where the auxiliary parts are respectively on the side walls closest to each other of two adjacent spacers of the plurality of spacers, the auxiliary parts, respectively on the side walls closest to each other of the two adjacent spacers, are connected or disconnected with each other.

**36.** The color filter structure according to claim 1 or 2, wherein the plurality of spacers are distributed in an array, and the spacers comprise first spacers and second spacers which are adjacent to each other and alternately arranged,

along a row direction, both two opposite side walls of the at least one side wall of the first spacer are provided with the auxiliary parts, and both two opposite side walls of the at least one side wall of the second spacer are not provided with the auxiliary part; and

along the column direction, both two opposite side walls of the at least one side wall of the first spacer are provided with the auxiliary parts, and both two adjacent side walls of the at least one side wall of the second spacer are not provided with the auxiliary part.

**37.** The color filter structure according to claim 1 or 2, wherein the plurality of spacers are distributed in an array,

along the row direction, the auxiliary parts are on two opposite side walls of the at least one side wall of each of the plurality of spacers, and the auxiliary parts, on the side walls closest to each other of two adjacent spacers of the plurality of spacers, are connected or disconnected with each other; and

along the column direction, the auxiliary parts are on two opposite side walls of the at least one side wall of each of the plurality of spacers, and the auxiliary parts, on the side walls closest to each other of two adjacent spacers of the plurality of spacers, are connected or disconnected with each other.

38. A display panel, comprising:
the color filter structure according to any one of claims 1 to 37, a plurality of light-emitting units on a base substrate, and the color control units are on a side of the plurality of light-emitting units away from the base substrate, and light emitted by the plurality of light-emitting units is emitted through the plurality of color control units.

39. The display panel according to claim 38, comprising sub-pixels arranged in an array, wherein the sub-pixels arranged in the array comprise a first sub-pixel, a second sub-pixel and a third sub-pixel,

each selected from a group consisting of the first sub-pixel, the second sub-pixel and the third sub-pixel comprises one of the light-emitting units and one of the color filter structure, and the one of the light-emitting units and the one of the color filter structure are laminated;
the display panel further comprises a light-emitting unit definition layer, wherein the light-emitting unit definition layer comprises a plurality of pixel openings, the plurality of light-emitting units are in the pixel openings in one-to-one correspondence, and an orthographic projection of each of the pixel openings is in an orthographic projection of one of the openings corresponding to the each of the pixel openings;
the display panel further comprises an isolation layer, wherein the plurality of the light-emitting units are spaced apart from the color filter structure by the isolation layer, and the color filter structure is directly on the isolation layer.

40. The display panel according to claim 39, wherein a side of the isolation layer away from the base substrate has an isolation layer opening area, and at least a part of at least one of the spacers is in the isolation layer opening area.

41. The display panel according to any one of claims 38 to 40, wherein light-emitting elements corresponding to the light-emitting units are organic light-emitting diode devices.

42. The display panel according to claim 41, wherein the first sub-pixel, the second sub-pixel and the third sub-pixel are respectively a red sub-pixel, a green sub-pixel and a blue sub-pixel, the color control unit in the red sub-pixel comprises a red quantum dot, the color control unit in the green sub-pixel comprises a green quantum dot, and the color control unit in the blue sub-pixel comprises at least one of a transparent resin and a blue quantum dot.

43. The display panel according to claim 42, wherein light emitted by the light-emitting elements is blue light.

44. A preparation method of a color filter structure, comprising:

providing a substrate;
forming a plurality of color control units and a pixel definition layer defining the plurality of color control units on the substrate,
wherein the plurality of color control units are respectively defined in a plurality of openings divided by the pixel definition layer;
the pixel definition layer comprises a plurality of spacers, each of the plurality of spacers separates two of the plurality of color control units from each other;
an auxiliary part is formed on at least one side wall of at least one of the spacers that faces the color control unit;
compactability of the auxiliary part is greater than or equal to that of a bottom of the at least one of the spacers.

45. The preparation method according to claim 44, wherein the compactability of the auxiliary part is greater than or equal to compactability of a surface of the at least one of the spacers in contact with an adjacent layer which is adjacent to the at least one of the spacers and is on a side close to the substrate.

46. The preparation method according to claim 44 or 45, wherein the auxiliary part comprises a light-transmissive first basic substance.

47. The preparation method according to claim 46, wherein the color control units comprise a first color control unit, and the openings comprise a first opening, and the first color control unit is defined in the first opening divided by the pixel definition layer;
the first color control unit comprises color conversion particles, and the color conversion particles are configured to convert light with a first wavelength into light with a second wavelength.

48. The preparation method according to claim 47, wherein the color control units further comprise a second color control unit, and the openings further comprise a second opening, and the second color control unit is defined in the second opening divided by the pixel definition layer; the second color control unit is configured to transmit light with the first wavelength entering the second color control unit with the first wavelength; and
the second color control unit comprises a light-transmissive second basic substance.

49. The preparation method according to claim 48, wherein the second color control unit comprises second scatter particles, and the second scatter particles are distributed in the second basic substance; the first basic substance is same as the second basic substance.

50. The preparation method according to claim 49, wherein a material of the auxiliary part adjacent to the second color control unit comprises the first scatter particles dispersed in the first basic substance, a material of the first scatter particles is same as that of the second scatter particles, and

a mass percentage of the second scatter particles in the second color control unit is smaller than that of the first scatter particles in the auxiliary part adjacent to the second color control unit.

51. The preparation method according to claim 50, wherein the first auxiliary part and the second auxiliary part are formed in a same process step, and forming the first auxiliary part and the second auxiliary part comprises:

forming a first ink comprising an uncured first basic substance and the first scatter particles in the plurality of the second openings, allowing at least a part of components in the first ink to permeate through at least one of the spacers to reach at least one of the first openings to form a second ink, wherein remaining components in the first ink form a third ink; and curing the second ink and the third ink to form the first auxiliary part on the side wall of the at least one spacer, which defines the at least one first opening, close to the at least one first opening, and to form the second auxiliary parts in the plurality of second openings.

52. The preparation method according to claim 50, wherein the first auxiliary part and the second color control unit are formed in a same process step, and forming the first auxiliary part and the second color control unit comprises:

forming a first ink comprising an uncured first basic substance and first scatter particles in the plurality of the second openings; allowing at least a part of components in the first ink to permeate through at least one of the spacers to reach at least one of the first openings to form a second ink, and remaining components in the first ink form a third ink; and curing the second ink and the third ink to form the first auxiliary part on the side wall, of the at least one spacer defining the at least one first opening, that is close to the at least one first opening, and to form the second color control units in the plurality of second openings.

53. The preparation method according to claim 50, wherein the second color control units and the auxiliary parts in the plurality of second openings are formed in a same process step, and forming the second color control units and the auxiliary parts comprises:

forming an auxiliary layer ink in at least a part of the first openings, and forming a second color control ink in the plurality of the second openings; and curing the auxiliary layer ink and the second color control ink to form the auxiliary parts on the side walls of the at least one spacer, which defines the at least one first opening, close to the corresponding first opening, and forming the second color control units in a plurality of second openings.

54. The preparation method according to claim 50, wherein the first auxiliary part and the second auxiliary part are formed in a same process step, and forming the first auxiliary part and the second auxiliary part comprises:

forming a first ink comprising an uncured first basic substance and first scatter particles in the plurality of the first openings; allowing at least a part of components in the first ink to permeate through at least one of the spacers to reach at least one of the second openings to form a second ink, and remaining components in the first ink form a third ink; and curing the second ink and the third ink to form the second auxiliary part on the side wall of the at least one spacer, which defines the at least one second opening, close to the at least one second opening, and to form the first auxiliary parts in the plurality of the first openings.

55. The preparation method according to claim 44, wherein a material of the spacer is heat curable resin, a material of the auxiliary part is ultraviolet curable resin, and the auxiliary part is formed by inkjet printing.

56. The preparation method according to claim 55, wherein a process of forming the auxiliary part by inkjet printing comprises:
forming the ultraviolet curable resin in the opening, performing an ultraviolet curing process on the material of the auxiliary part after pre-infiltration to form the auxiliary part, and before the pre-infiltration, a volume of the ultraviolet curable resin is 90% to 120% of an accommodating space of the opening.

57. The preparation method according to claim 56, wherein the ultraviolet curable resin is a resin material containing nanoparticles, a viscosity of the ultraviolet curable resin at room temperature is in a range of 5 cps to 12 cps, and a surface tension of the ultraviolet curable resin is in a range of 30 mN/m to 35 mN/m.

58. The preparation method according to claim 44, wherein a material of the spacer is heat curable resin, a material of the auxiliary part is titanium oxide or silicon oxide, the auxiliary part is formed by a photolithography process, and the auxiliary part is formed before or after the spacer is formed.

FIG. 1

FIG. 2

FIG. 3

FIG. 4

FIG. 5

107a/106a

FIG. 6

( a )

( b )

( c )

( d )

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

FIG. 29

FIG. 30

FIG. 31

FIG. 32

FIG. 33

FIG. 34

FIG. 35

FIG. 36

FIG. 37

| providing a substrate | S11 |
|---|---|

| forming a plurality of color control units and a pixel definition layer defining the plurality of color control units on the substrate, in which the color control units are respectively defined in a plurality of openings divided by the pixel definition layer, and the pixel definition layer comprises a plurality of spacers, each of the plurality of spacers separates two of the plurality of color control units from each other, an auxiliary part is formed on at least one side wall of at least one of the spacers that faces the color control unit, and compactability of the auxiliary part is greater than or equal to that of a bottom of the at least one of the spacers | S12 |
|---|---|

FIG. 38

| forming a first ink comprising an uncured first basic substance and the first scatter particles in the plurality of the second openings | S21 |
|---|---|
| allowing at least a part of components in the first ink to permeate through at least one of the spacers to reach at least one of the first openings to form a second ink, in which remaining components in the first ink form a third ink | S22 |
| curing the second ink and the third ink to form the first auxiliary part on the side wall of the at least one spacer, which defines the at least one first opening, close to the at least one first opening, and to form the second auxiliary parts in the plurality of second openings | S23 |

FIG. 39A

FIG. 39B

Curing by ultraviolet irradiation

FIG. 39C

| forming a first ink comprising an uncured first basic substance and first scatter particles in the plurality of the second openings | S31 |
| allowing at least a part of components in the first ink to permeate through at least one of the spacers to reach at least one of the first openings to form a second ink, and remaining components in the first ink form a third ink | S32 |
| curing the second ink and the third ink to form the first auxiliary part on the side wall, of the at least one spacer defining the at least one first opening, that is close to the at least one first opening, and to form the second color control units in the plurality of second openings | S33 |

FIG. 40

FIG. 41A

FIG. 41B

Curing by ultraviolet irradiation

FIG. 41C

| forming an auxiliary layer ink in at least a part of the first openings, and forming a second color control ink in the plurality of the second openings | ~S41 |

↓

| curing the auxiliary layer ink and the second color control ink to form the auxiliary parts on the side walls of the at least one spacer, which defines the at least one first opening, close to the corresponding first opening, and forming the second color control units in a plurality of second openings | ~S42 |

FIG. 42

| forming a first ink comprising an uncured first basic substance and first scatter particles in the plurality of the first openings | ~S51 |

↓

| allowing at least a part of components in the first ink to permeate through at least one of the spacers to reach at least one of the second openings to form a second ink, and remaining components in the first ink form a third ink | ~S52 |

↓

| curing the second ink and the third ink to form the second auxiliary part on the side wall of the at least one spacer, which defines the at least one second opening, close to the at least one second opening, and to form the first auxiliary parts in the plurality of the first openings | ~S53 |

FIG. 43

FIG. 44A

FIG. 44B

FIG. 45A

47

FIG. 45B

FIG. 45C

FIG. 45D

FIG. 45E

FIG. 45F

FIG. 45G

FIG. 45H

FIG. 45I

## INTERNATIONAL SEARCH REPORT

| International application No. |
| --- |
| **PCT/CN2021/093966** |

### A.    CLASSIFICATION OF SUBJECT MATTER

H01L 27/32(2006.01)i;  G02F 1/133(2006.01)i

According to International Patent Classification (IPC) or to both national classification and IPC

### B.    FIELDS SEARCHED

Minimum documentation searched (classification system followed by classification symbols)

H01L; G02F

Documentation searched other than minimum documentation to the extent that such documents are included in the fields searched

Electronic data base consulted during the international search (name of data base and, where practicable, search terms used)

CNTXT; CNABS; VEN; CNKI: 滤色, 滤光, 色过滤, 色转换, 色阻, 滤波, 间隔, 隔离, 隔壁, 墙, 分隔, 围堰, 隔墙, 量子点, 发光, 显示, 渗透, 扩散, 渗入, 墨水, 液体, 墨液, 液滴, 喷墨, color, colour, filter, convert, film, spacer, partition, wall, quantum dot, light emitting, display, permeate, diffuse, ink, liquid, drop

### C.    DOCUMENTS CONSIDERED TO BE RELEVANT

| Category* | Citation of document, with indication, where appropriate, of the relevant passages | Relevant to claim No. |
| --- | --- | --- |
| X | CN 111430425 A (BOE TECHNOLOGY GROUP CO., LTD.) 17 July 2020 (2020-07-17) description, paragraphs [0046]-[0088], and figures 3 and 8 | 1-8, 11-15, 18, 27, 32, 38-41, 44-47, 55-58 |
| Y | CN 111430425 A (BOE TECHNOLOGY GROUP CO., LTD.) 17 July 2020 (2020-07-17) description, paragraphs [0046]-[0088], figures 3 and 8 | 9, 10, 16, 17, 19-23, 25, 28, 29, 33-37, 42, 43, 48, 49 |
| Y | CN 109283750 A (SAMSUNG DISPLAY CO., LTD.) 29 January 2019 (2019-01-29) description, paragraph [0159], figures 7A and 11B | 9, 10, 33-37 |
| Y | CN 112599575 A (BEIJING VISIONOX TECHNOLOGY CO., LTD.) 02 April 2021 (2021-04-02) see description, paragraphs [0030]-[0062], and figure 7 | 16, 17, 19-23, 25, 28, 29, 42, 43, 48, 49 |
| A | US 2021028236 A1 (SAMSUNG DISPLAY CO., LTD.) 28 January 2021 (2021-01-28) entire document | 1-58 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **10 February 2022** | **17 February 2022** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/093966**

| Patent document cited in search report | | | Publication date (day/month/year) | Patent family member(s) | | | Publication date (day/month/year) |
|---|---|---|---|---|---|---|---|
| CN | 111430425 | A | 17 July 2020 | None | | | |
| CN | 109283750 | A | 29 January 2019 | KR | 20190010821 | A | 31 January 2019 |
| | | | | US | 2019025634 | A1 | 24 January 2019 |
| | | | | US | 11061268 | B2 | 13 July 2021 |
| CN | 112599575 | A | 02 April 2021 | None | | | |
| US | 2021028236 | A1 | 28 January 2021 | KR | 20210012101 | A | 03 February 2021 |
| | | | | CN | 112305807 | A | 02 February 2021 |

Form PCT/ISA/210 (patent family annex) (January 2015)